# EUROPEAN PATENT SPECIFICATION

(11) **EP 4 632 795 B1**
(45) Date of publication and mention of the grant of the patent: **07.10.2026**
(21) Application number: 23918613.3
(22) Date of filing: 19.12.2023
(51) Int. Cl.: B23K 26/00, B23K 26/042, B23K 26/53, B23K 26/361

(54) **CHAMFERING METHOD AND CHAMFERING DEVICE**
ANFASVERFAHREN UND ANFASVORRICHTUNG
PROCÉDÉ DE CHANFREINAGE ET DISPOSITIF DE CHANFREINAGE

(30) Priority: 25.01.2023 JP 2023009407; 25.01.2023 JP 2023009414; 09.03.2023 JP 2023036728
(43) Date of publication of application: 15.10.2025
(73) Proprietor: Tokyo Seimitsu Co., Ltd., Hachioji-shi, Tokyo 192-8515 (JP)
(72) Inventor: TSURU, Taira, Tsuchiura-shi, Ibaraki 300-0015 (JP)
(74) Representative: Seemann & Partner Patentanwälte mbB
(86) International application number: PCT/JP2023/045439
(87) International publication number: WO 2024/157659

(56) References cited:
- WO-A1-2009/157319
- WO-A1-2009/157319
- JP-A- 2002 241 141
- JP-A- 2002 241 141
- JP-A- 2004 111 606
- JP-A- 2009 066 851
- JP-A- 2009 066 851
- JP-A- 2019 212 761
- JP-A- 2019 212 761
- JP-A- 2022 136 730
- JP-A- H09 225 665

## Description

### Field

The present disclosure relates to a wafer chamfering method forming a slope on the perimeter of a wafer to chamfer the wafer and a chamfering device for use in the same. The present disclosure, as an aspect, relates to a chamfering method and a chamfering device suitable for the production of SiC wafers, a semiconductor material that has been put to practical use for power devices in recent years.

### Background

The demand for improving the quality of wafers has become stronger in recent years, and more importance has been placed on the processing condition of a wafer end face (an edge). Semiconductor wafers such as silicon (Si) wafers are subjected to chamfering typically forming a slope by grinding the edge in order to prevent chipping due to handling. Furthermore, this is often followed by mirror finishing by polishing.

Semiconductors containing materials that have a large band gap (ultra wide band gap (UWBG)), have strong bonds between atoms making up crystals, and are hard to destroy, such as silicon carbide (SiC) as a compound of carbon (C) and silicon (Si), gallium nitride (GaN), gallium oxide, aluminum gallium nitride (AlGaN), and diamond, are expected as power devices and high-frequency devices that have smaller size and lower power consumption and/or higher efficiency and/or semiconductor materials having better radiation resistance than silicon semiconductors, and their practical application is progressing.

JP 2004-111606 A states that, in a chamfering method chamfering a peripheral edge of a wafer, coarse grinding with a grinding wheel for coarse grinding is omitted, and to reduce a processing time and reduce running costs, a laser beam is made incident obliquely along the perimeter near the edge of the wafer to form a modified area layer by multiphoton absorption inside, the edge is obliquely cut and removed, and then finishing with a grinding wheel for precise grinding is performed.

JP 2019-212761 A states that to efficiently perform chamfering on the perimeter of a wafer, a laser beam's focal point is positioned at the perimeter of the wafer to roughly perform chamfering by laser ablation (applying a laser beam with high photon density to instantaneously melt and vaporize the material surface), and then the perimeter of the wafer is ground with a grinding wheel to perform finishing.

JP 2002-241141 A discloses a method for chamfering a glass plate to prevent cracking at the corners, wherein a CO₂ laser beam focused on the edge of a glass plate tilted at an angle is irradiated, and the laser beam is scanned relative to the edge line to remove the upper corner of the irradiated surface edge.

Moreover, JP 2009-066851 A1 describes a chamfering method for chamfering an outer periphery of a wafer. The chamfering method comprises: a roughing process in which a laser beam is irradiated onto the outer periphery of a wafer by positioning the focal point of the laser beam there, thereby performing rough chamfering by ablation; and a finishing process in which the outer periphery of the ablated wafer with a grinding wheel to perform a finishing process.

In addition, WO 2009/157319 A1 discloses a chamfering apparatus for chamfering or rounding a brittle material substrate.

### Citation List

### Patent Literature

JP 2004-111606 A
JP 2019-212761 A
JP 2002-241141 A
JP 2009-066851 A
WO 2009/157319 A1

### Summary

### Technical Problem

UWBG materials such as 4H-SiC are materials that are hard and difficult to process (difficult-to-process materials), and the conventional technologies described in JP 2004-111606 A and JP 2019-212761 A have had problems in that it takes time for processing, it is difficult to create desired shapes, and a reduction in grinding costs is not sufficient due to intense wear of grinding wheels.

There is also a problem with the method of first applying laser ablation technology to remove the corner of a SiC wafer, and then performing finishing with the grinding wheel in order to avoid wear of the grinding wheel. That is, when the area to be removed by the laser is large, increasing laser output causes thermal stress to cause cracks to propagate, debris is generated, and it is difficult to control removal shape (quality). Processing methods by the conventional technologies are all not realistic as a chamfering method for difficult-to-process materials in terms of time, quality, and price.

An object of the present disclosure is to solve at least any of the problems of the conventional technologies. An object thereof is to provide a wafer chamfering method that can perform chamfering of the perimeter and the orientation flat (OF) of UWBG material wafers such as 4H-SiC, which are difficult-to-process materials, especially SiC wafers, using a laser, with suitable quality for post-processes such as polishing and a chamfering device for use in the chamfering method. Note that the suitable quality includes high-precision shape formation and uniform surface states (waviness and roughness).

### Solution to Problem

An embodiment of the chamfering method of the present disclosure is a chamfering method forming a slope on a perimeter of a wafer to chamfer the wafer, the chamfering method including performing pre-processing to create in advance an irradiation surface to be perpendicular to the slope to be formed, and applying a laser such that the laser is perpendicularly applied to the irradiation surface to penetrate the wafer along the slope.

An embodiment of the chamfering device of the present disclosure is a chamfering device forming a slope on a perimeter of a wafer to chamfer the wafer, the chamfering device including a laser application part configured to apply a laser to the wafer, a workpiece moving stage configured to hold the wafer and having a structure with five axes including three axes of an X axis, a Y axis, and a Z axis and additional two axes of a yaw axis for rotation and a pitch axis for tilt, and a control device, in which the control device performs movement of the five axes with an attitude changing program, controls the laser application part to create in advance an irradiation surface to be perpendicular to the slope, and then applies the laser such that the laser is perpendicularly applied to the irradiation surface to penetrate the wafer along the slope.

### Advantageous Effects of Invention

The chamfering method of the present disclosure solves at least any of the problems of the conventional technologies. As a specific effect, the chamfering method of the present disclosure can perform chamfering of the perimeter and the orientation flat (OF) of UWBG material wafers such as 4H-SiC, which are difficult-to-process materials, especially SiC wafers, using a laser, with suitable quality for post-processes such as polishing and a chamfering device for use in the chamfering method. The present disclosure also provides a chamfering device.

### Brief Description of Drawings

FIG. 1A is an illustration of an example of a chamfering method for a wafer W using a laser, the diagram illustrating the crystal orientation, the shape, and the orientation flat (OF) of the wafer W, which is 4H-SiC.
FIG. 1B is a diagram of an upper half section of the area surrounded by the dashed line in FIG. 1A (a perimeter to be chamfered).
FIG. 1C is a flowchart of a procedure of the chamfering method.
FIG. 2 is a sectional illustration of a state in which a laser 10 is applied to an irradiation surface L.
FIG. 3 is an illustration of shape processing of the wafer W.
FIG. 4A is a configuration diagram of a laser application part.
FIG. 4B is a diagram of a detailed shape of a section of the end of the processed wafer W (the area surrounded by the circle drawn by the dashed line in FIG. 4A).
FIG. 5 is a functional block diagram of an example of a chamfering device.
FIG. 6 is a flowchart of a method for constructing a control model for the chamfering method.
FIG. 7A is a sectional illustration of processing of an R section RS (a connection between an end face and a slope SL, with a target shape being usually curved) in a chamfer.
FIG. 7B is a sectional illustration of processing of the R section RS in the chamfer.
FIG. 8A is a side view of the end of the wafer W after chamfering.
FIG. 8B is a configuration diagram of a laser application part 10-3, showing finishing of the R section RS and the slope SL.
FIG. 8C is an enlarged view of the end (the area surrounded by the dashed line circle in FIG. 8B).
FIG. 8D is a diagram of an irradiation state by finishing of an end face ED.
FIG. 9 is a diagram of an upper half section of a perimeter to be chamfered.
FIG. 10 is a sectional illustration of a state in which the laser is being applied along the slope while changing its processing depth.
FIG. 11 is a sectional illustration of a method for applying a laser to the end in the finishing or the like.
FIG. 12 is a configuration diagram of the laser application part.
FIG. 13 is a sectional view of the shape of a notch of the wafer W.
FIG. 14 is a flowchart of the chamfering method.
FIG. 15 is an illustration of a main part of a chamfering device.
FIG. 16 is a hardware configuration diagram of the chamfering device.
FIG. 17 is a flow diagram of chamfering of the wafer by the chamfering device.
FIG. 18A is an illustration of the positional relation among the wafer W, a first laser, and a second laser at Steps S31 to S33 in FIG. 14.
FIG. 18B is a partial sectional view of a wafer end at the A-A' line.
FIG. 18C is a diagram of a state (a wafer W') in which the wafer W has been moved in a direction ax1 by a moving mechanism.
FIG. 19A is an illustration of a first modification of a method for adjusting an irradiation position.
FIG. 19B is a partial sectional view of the wafer end at the A-A' line.
FIG. 20A is a diagram of a second modification of the method for adjusting an irradiation position.
FIG. 20B is a partial sectional view of the wafer end at the B-B' line.
FIG. 21A is an illustration of the positional relation among the wafer W, the first laser L1, and the second laser L2.
FIG. 21B is a partial sectional view of the wafer end at the C-C' line.
FIG. 21C is a diagram of a state (the wafer W') in which the wafer W has been moved in the direction ax1 by the moving mechanism.
FIG. 22A is a partial sectional view of the wafer end at the D-D' line.
FIG. 22B is a diagram of a state (the wafer W') in which the wafer W has been moved in a direction ax2 by the moving mechanism.
FIG. 23A is a plan view of the shape of the notch after chamfering.
FIG. 23B is a partial sectional view of the wafer end at the E-E' line.
FIG. 24A is an illustration of a method for applying lasers to the notch.
FIG. 24B is an illustration of the method for applying lasers to the notch.
FIG. 24C is an illustration of the method for applying lasers to the notch.
FIG. 24D is an illustration of the method for applying lasers to the notch.
FIG. 25 is an illustration of a method for adjusting the energy density distribution of a laser for use in surface treatment.
FIG. 26 is a functional block diagram of the chamfering device.
FIG. 27 is a flow diagram of a method for acquiring a record of a training data set using the chamfering device.

### Description of Embodiments

A first embodiment of the chamfering method of the present disclosure is a chamfering method forming a slope on a perimeter of a wafer to chamfer the wafer, the chamfering method including performing pre-processing to create in advance an irradiation surface to be perpendicular to the slope to be formed, and applying a laser such that the laser is perpendicularly applied to the irradiation surface to penetrate the wafer along the slope.

According to the first embodiment, the pre-processing to create in advance an irradiation surface L to be perpendicular to a slope S to be chamfered is performed, and the laser is applied such that the laser is perpendicularly applied to the irradiation surface L to penetrate a wafer W along the slope S, and thus in chamfering of a UWBG material wafer, which is a difficult-to-process material, especially a SiC wafer, high-precision shape formation is achieved, and processing quality can be improved without producing any processing degenerated layers or the like.

A second embodiment of the chamfering method of the present disclosure is the chamfering method according to the first embodiment, in which, in the applying a laser, application of a pulsed laser and application of a continuous wave (CW) laser are used together.

According to the second embodiment, since the pulsed laser and the continuous wave laser are used together, temperature changes of the wafer W, including the irradiation surface, are inhibited more easily than using only the pulsed laser. Inhibition of abrupt temperature changes leads to a reduction in a load due to repetitive thermal stress caused by the application of the pulsed laser. This facilitates inhibition of the occurrence of defects such as dislocations and further improves the quality of a processed surface (the slope).

A third embodiment of the chamfering method of the present disclosure is the chamfering method according to the second embodiment, in which the pulsed laser has a wavelength λ of 515 nm or longer and 1,080 nm or shorter.

A fourth embodiment of the chamfering method of the present disclosure is the chamfering method according to any one of the first to third embodiments, in which a material of the wafer is SiC.

A fifth embodiment of the chamfer processing method of the present disclosure is the chamfering method according to any one of the first to third embodiments, in which a material of the wafer is any one selected from the group consisting of 4H-SiC, 3C-SiC, 6H-SiC, 15R-SiC, GaN (gallium nitride), gallium oxide, AlGaN, and diamond.

A sixth embodiment of the chamfering method of the present disclosure is the chamfering method according to any one of the first to third embodiments, further including applying atmospheric pressure water vapor plasma to a cut surface with the laser.

A seventh embodiment of the chamfering method of the present disclosure is the chamfering method of any one of the first to third embodiments, further including performing laser annealing as finishing of a cut surface after forming the slope with the laser.

An eighth embodiment of the chamfering method of the present disclosure is the chamfering method according to any one of the first to third embodiments, in which the irradiation surface is amorphized by the pre-processing.

A first embodiment of the chamfering device of the present disclosure is a chamfering device forming a slope on a perimeter of a wafer to chamfer the wafer, the chamfering device including a laser application part configured to apply a laser to the wafer, a workpiece moving stage configured to hold the wafer and having a structure with five axes including three axes of an X axis, a Y axis, and a Z axis and additional two axes of a yaw axis for rotation and a pitch axis for tilt, and a control device, in which the control device performs movement of the five axes with a computer program stored in advance, controls the laser application part to create in advance an irradiation surface to be perpendicular to the slope, and then applies the laser such that the laser is perpendicularly applied to the irradiation surface to penetrate the wafer along the slope.

### [First Example]

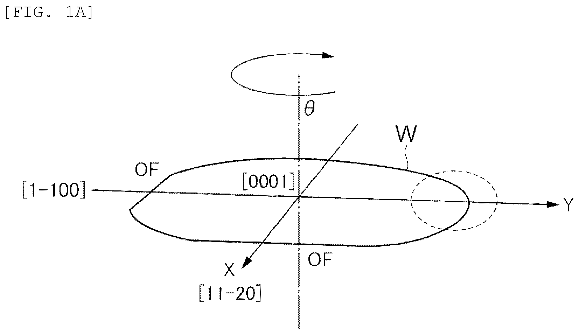

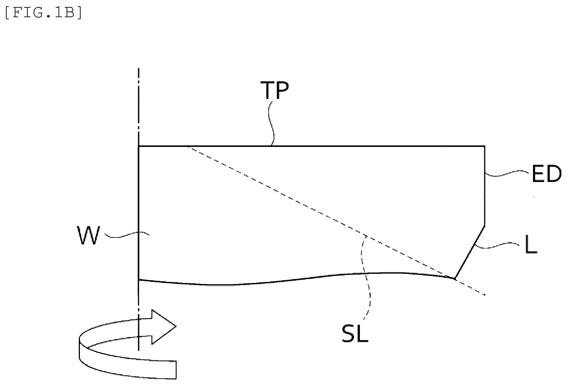

FIGS. 1A and 1B are illustrations of an example of a chamfering method for the wafer W (a SiC wafer) using a laser. Of these, FIG. 1A is a diagram of the crystal orientation, the shape, and the orientation flat (OF) of the wafer W, which is 4H-SiC.

FIG. 1B is a diagram of an upper half section of the area surrounded by the dashed line in FIG. 1A (a perimeter to be chamfered).

The main feature of SiC semiconductors is that they have a band gap that is three times wider than that of Si semiconductors and are expected to have lower power consumption, higher efficiency, and/or smaller size when made into devices. There are various polytypes (crystal polymorphs) of SiC, their names are classified by crystal structure, and they have different physical property values; 4H-SiC is considered to be the optimum for the wafer W for power devices.

In the case of an upper slope of the wafer W (FIG. 1B), the chamfering is performed from obliquely below the slope S (to be) chamfered. Specifically, this is performed by applying a laser from a certain angle to the wafer W rotating in the arrow direction (clockwise) illustrated in FIG. 1A. For a lower slope, the opposite is performed.

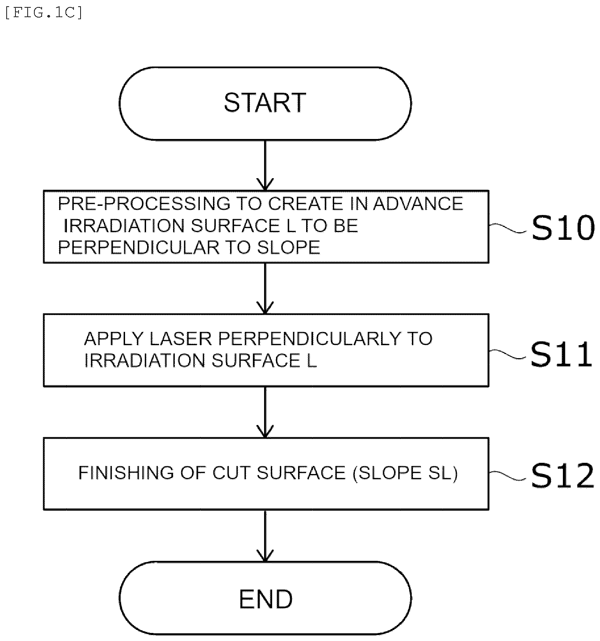

Note that the rotation direction may be counterclockwise. FIG. 1C is a flowchart of a procedure of the chamfering method. The details of each step will be described below along the flowchart.

First, as Step S10, pre-processing to create in advance an irradiation surface L to be perpendicular to the slope (to be) formed by the chamfering is performed.

The size of the irradiation surface L may be a few tens of micrometers to 1 mm ("to" means a range including the values before and after it; the same applies below). Although the pre-processing may be other than laser processing, it is desirable to amorphize the irradiation surface L and the slope SL by laser application.

By forming the irradiation surface L perpendicular to the slope SL to be formed, the laser application at the later stage is more likely to be performed more efficiently. Specifically, by making the laser incident perpendicularly on the irradiation surface L, scattering of the laser on the surface of the wafer W can be inhibited. The present example makes it possible to process even the wafer W having a disk shape (a thin cylinder shape) and having an edge not ground at all (unprocessed), in other words, having a corner.

Note that the "perpendicular" irradiation surface L means that the angle to the slope SL is within a range of 80 deg or more and 100 deg or less, which is preferably within a range of 85 deg or more and 95 deg or less, and more preferably 90 deg.

In particular, in the processing of difficult-to-process materials, there are problems in that it takes a long time for processing an unprocessed edge and grinding wheel life is extremely shortened by such processing. Meanwhile, when attempting to form a slope with a laser, it is often difficult to process the unprocessed edge into a targeted shape due to scattering or the like.

In contrast, in the present example, since the irradiation surface L is formed in advance, scattering or the like is less likely to occur even when the slope SL is formed with a laser (laser application can be performed at an angle in which scattering is less likely to occur), and as a result, processing to the targeted shape is likely to be easier.

Next, as Step S11, a laser is perpendicularly applied to the irradiation surface L. In this case, the laser is applied in a direction along the slope SL.

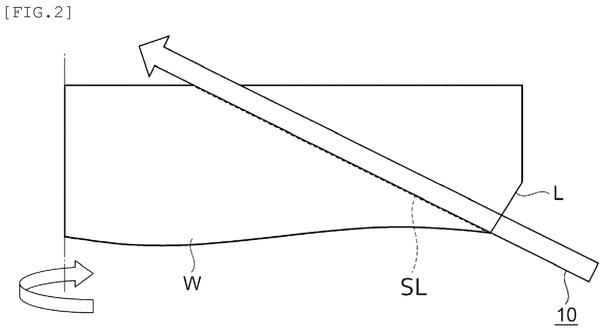

FIG. 2 is a sectional illustration of a state in which a laser 10 is applied to the irradiation surface L. The laser 10 is applied such that the laser is perpendicularly applied to the irradiation surface L to penetrate part of the wafer W along the slope SL with an incident angle of, as an example, within ±5 degrees (deg). The penetration power by the laser 10 is also greatly affected by a polarization state and a pulse width. For example, the laser 10 is set up as a single-shot picosecond or nanosecond pulsed laser with a wavelength of λ = 515 nm to 1,080 nm.

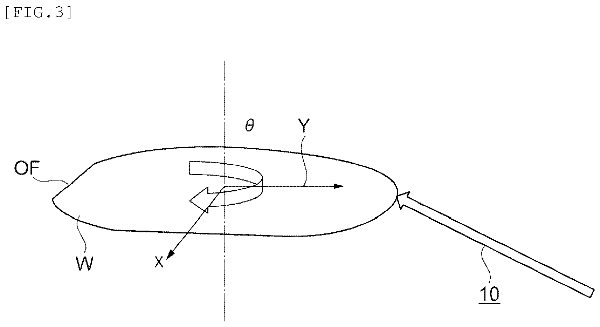

FIG. 3 is an illustration of shape processing of the wafer W. The chamfering is performed by applying the laser while sequentially moving an irradiation point by moving the wafer W and cutting it into a desired shape. This is reminiscent of a process such as cutting an edge using a thread saw. Note that the laser 10 is applied to the edge of the wafer W by moving θ (the yaw axis) for a circumferential part and moving the X and Y axes for the orientation flat (OF) part.

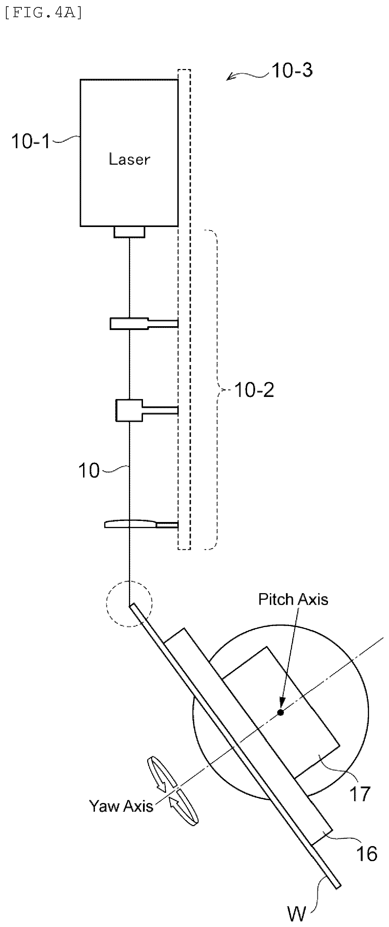

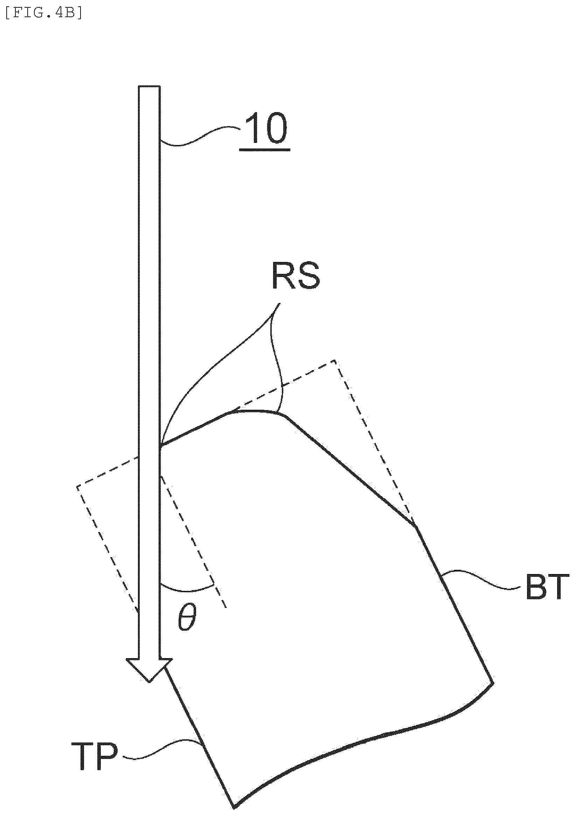

FIG. 4A is a more specific configuration diagram of the laser application part. FIG. 4B is a diagram of a detailed shape of a section of the end of the processed wafer W (the area surrounded by the circle drawn by the dashed line in FIG. 4A). The end of the wafer W has a top surface TP, a bottom surface BT, and an R section RS. In the present example, the top surface TP and the bottom surface BT are horizontal surfaces. The bottom surface BT is identical to the top surface TP.

A laser application part 10-3 emits the laser 10 from a laser light source 10-1. For example, the laser 10 the energy density distribution of which is a Gaussian distribution is adjusted (typically enlarged) in spot diameter or the like by a focusing optical system 10-2 including a beam expander or the like.

The focusing optical system 10-2 can also include a homogenizer (a diffractive optical element), a waveplate, and a polarizer. The laser reaches the irradiation surface L through such a focusing optical system 10-2. The focusing optical system 10-2 can also include a mask of a certain shape. The shape of a laser spot may be adjusted by the mask. For example, the laser may be passed through a mask having a window, such as a semicircular shape, and the spot shape may be formed in accordance with the window shape.

For the mask, ones formed with a window of a certain shape with chromium or blackened metallic silver as a light-blocking film on glass, synthetic quartz, or polymer film can be used. The window shape of the mask can be formed not only in a semicircular shape. The profile of the energy density of the laser (a beam profile) may be adjusted by the homogenizer (the diffractive optical element) that the focusing optical system 10-2 can include, apart from the mask, or they may be used together.

The focusing optical system 10-2 can include a focusing lens including a plano-convex lens or the like. The laser is focused into a certain spot shape by the focusing lens. The energy density can be adjusted comprehensively by adjusting the size of the laser spot at an irradiation position, the degree of focusing, the pulse width, the polarization state, and the beam profile. The focusing optical system 10-2 can include a prism optical system in addition to the above or instead of the above.

The wafer W as a workpiece is held by a vacuum chuck table 16 on a workpiece moving stage 17 that can change its attitude. The workpiece moving stage 17 has a five-axis structure including three axes of an X axis, a Y axis, and a Z axis and additional two axes of a yaw axis for rotation and a pitch axis for tilt. The laser 10 may use continuous wave (CW) laser application and picosecond or nanosecond pulsed laser application together. The laser 10 enters perpendicularly to the irradiation surface L through the focusing optical system 10-2 and penetrates along the slope SL to be chamfered. Combination with the continuous wave (CW) laser prevents abrupt temperature changes more easily, reduces a load due to repetitive thermal stress, and inhibits the occurrence of dislocations more easily.

The wavelength λ of the continuous wave (CW) laser is, for example, preferably 515 nm or longer and 1,080 nm or shorter, and more preferably 800 nm or longer and 1,080 nm or shorter. An irradiation condition is determined in accordance with crystal orientation and shape so that the cumulative value of the irradiation energy (the cumulative irradiation energy) of the laser 10 to an irradiation place becomes a certain value. This prevents abrupt temperature changes, reduces a load due to repetitive thermal stress, and inhibits the occurrence of dislocations.

Note that when the irradiation surface L is amorphized by laser application as the pre-processing at Step S10, the laser is a single-shot picosecond or nanosecond pulsed laser with a wavelength λ of 515 nm or longer and 1,080 nm or shorter, with a low intensity not higher than a processing threshold of SiC as the material of the wafer W. The fluence (photon density: energy per unit area) of the picosecond or nanosecond pulsed laser is made lower than the fluence at which laser ablation occurs. SiC has an inherent processing threshold, and with a nanosecond pulsed laser with a specific condition (for example, within a range of 2 to 4 nanoseconds), the targeted part of the slope SL will be heated by absorption at an irradiation position of the laser, causing modification and making it a-Si (amorphous silicon).

The wavelength of the laser and the conditions of the pulsed laser may be the same or different between the case of amorphizing the irradiation surface L by laser application as the pre-processing and the case of applying the laser 10 to the irradiation surface L so as to penetrate part of the wafer W already described. In particular, both the conditions are preferably identical in that they are each within a certain range in that the processing can be performed more efficiently. One specific example of that range is a single-shot picosecond or nanosecond pulsed laser with a wavelength λ of 515 nm or longer and 1,080 nm or shorter.

In this case, as one form, when the irradiation surface L is amorphized by laser application as the pre-processing, the pulse width can be increased in a pseudo manner by using a form of application in which picoseconds are overlapped as a plurality of pulse trains (a method called "burst mode"). This makes it easier to be adjusted to a range that does not exceed the processing threshold even using the single-shot picosecond or nanosecond pulsed laser with a wavelength λ of 515 nm or longer and 1,080 nm or shorter and enables the amorphization to proceed more efficiently.

In this case, the amorphization of the irradiation surface L and the subsequent processing of the wafer W may be performed continuously.

When the amorphization of the irradiation surface L is also performed at Step S10, the laser 10 applied along the slope SL at Step S11 is preferably at a wavelength that is easily absorbed by an amorphous layer. In that case, the laser 10 is at a wavelength that is easily absorbed by the amorphous layer, especially an amorphous silicon layer in SiC. When the absorption of the laser 10 is made more efficient, the modified part (the amorphous layer) melts efficiently, enabling more precise processing.

A femtosecond laser can also be used as the laser 10. The wavelength λ of the femtosecond laser is preferably 515 nm or longer and 1,080 nm or shorter, more preferably 800 nm or longer and 1,080 nm or shorter, and, as a specific form, even more preferably 800 nm. When the irradiation surface L is amorphized in the pre-processing (Step S10), there is a method in which the applied femtosecond laser is single shot with a low intensity not higher than the processing threshold of a c-Si (single crystal silicon) layer.

The femtosecond laser is a laser emitting light for only a few femtoseconds to a few hundred femtoseconds, in which the time unit is treated in a "femto" (one quadrillionth) unit. There is a method in which the laser 10, which is a femtosecond laser, selectively applies a pulsed laser of 355, 532, and 785 nm, which are wavelengths with a high absorption rate for a-Si (amorphous silicon), to the part modified to a-Si (amorphous silicon). On the irradiation surface, melting of a-Si occurs, and epitaxial growth promotes the formation of a single crystal with aligned crystal orientation.

The material of the wafer W (SiC, gallium nitride (GaN), gallium oxide, AlGaN, diamond, or the like), the wavelength, the pulse width, and the like of the laser have known effects on laser application fluence. By adjusting the wavelength, intensity, pulse width, repetition frequency, the degree of focusing, pulse width, polarization state, beam profile, and the like of the laser in accordance with the material of the target wafer W, the intensity of the laser can be adjusted to be not higher than the processing threshold. The method for adjusting the laser intensity according to the material itself has been widely studied and is known to those skilled in the art.

Next, as Step S12, finishing of the cut surface (the slope SL) is performed. By performing the finishing, the wafer W having suitable quality for post-processes such as polishing is easily obtained. The method of the finishing is not limited to a particular method, but examples thereof include methods such as formation of an R section by laser application, surface treatment by plasma application, and surface treatment by laser annealing.

First, the formation of the R section (symbol: RS) by laser application will be described.

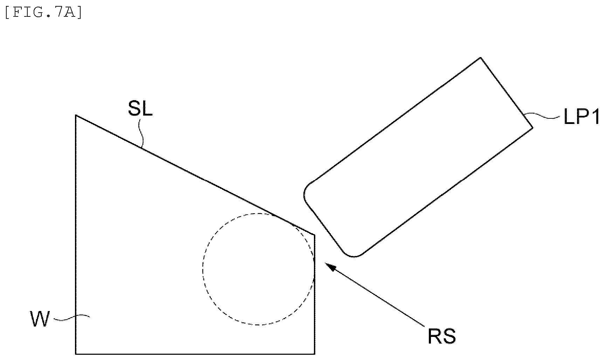

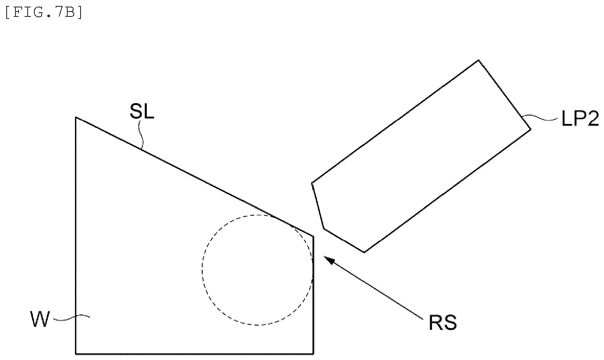

FIG. 7A and FIG. 7B are sectional illustrations of processing of the R section RS (a connection between an end face and the slope SL, with a target shape being usually curved) in a chamfer, with only the upper surface side shown. The processing of the R section RS is performed after the slope SL is formed by the laser 10. FIG. 7A schematically represents that the beam profile of the applied laser is made a flat-top shape LP1. FIG. 7B schematically represents that the beam profile is made a triangular shape LP2.

Since the processing of the R section RS is finishing, the profile of the applied beam is made into the flat-top shape LP1 or the triangular shape LP2 by a homogenizer or the like forming the profile (power distribution) of the laser beam to be applied to the R section RS. The formation of the R section RS may be performed by application a plurality of times from different angles or simultaneous application from different angles.

Next, the surface treatment of the slope SL by laser application will be described. The surface treatment by laser application may be in the form of melting and solidifying the surface to flatten the surface by laser annealing. The laser annealing is preferably performed by applying a laser to an amorphous film to melt and crystallize it, and typically preferably performed with a pulsed laser at a photon density (fluence) of a value smaller than a processing threshold (laser ablation). The laser annealing can then advance recrystallization (epitaxial growth) with aligned crystal orientation and eliminate the effects of crystal orientation, crystal defects, and the like.

When the finishing of the cut surface is performed by the laser annealing, the laser 10 may be a laser beam with high fluence. In this case, the surface of the irradiated slope SL instantly melts and evaporates, releasing ions, atoms, radicals, molecules, clusters, solid fragments, and the like in a fast process.

In the finishing of the slope SL, which is a plane, the incident angle of the laser is preferably almost perpendicular to the slope SL to be the irradiation surface. On the other hand, the R section RS is an irradiation place with curvature, and thus it is difficult to apply the laser perpendicularly across the irradiation place. Thus, it is preferable to section (discretize) the irradiation place with curvature, change the laser incident angle, and apply the laser perpendicularly to a laser irradiation surface for each section. Also, the irradiation place with curvature can easily be made more efficient by increasing a scan pitch (or reducing the cumulative number of times of application) to shorten throughput.

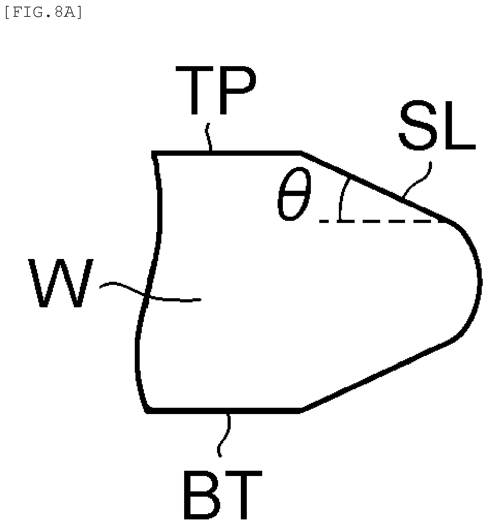

FIG. 8A is a side view of the end of the wafer W after the chamfering. FIG. 8A is an example of the chamfering, in which the wafer W includes a top surface TP and a bottom surface BT, which are parallel to each other, and the slope SL, and the slope SL has a slope with an angle θ.

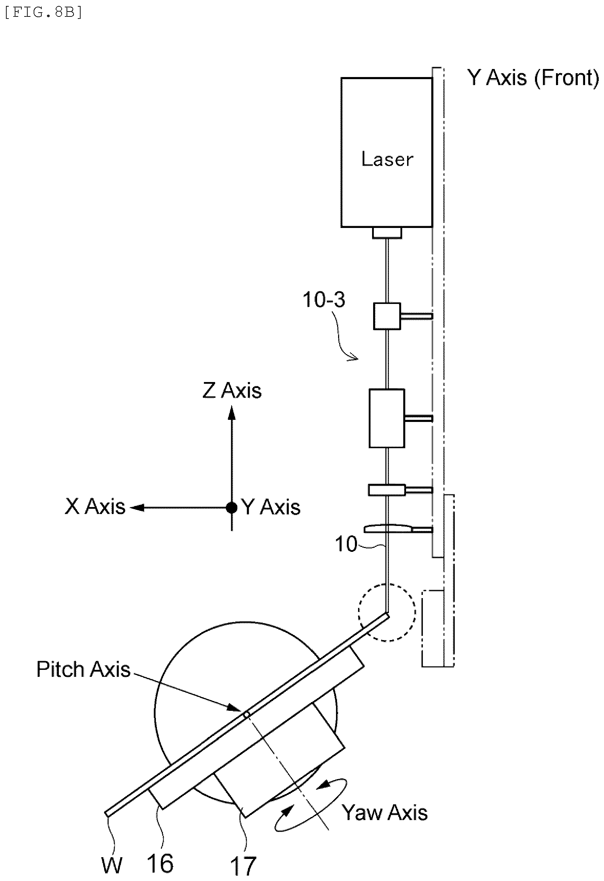

FIG. 8B is a configuration diagram of the laser application part 10-3, showing the finishing of the R section RS and the slope SL, the diagram being a Y-axis front view of the relation between the laser 10 and the wafer W when the R section RS is irradiated.

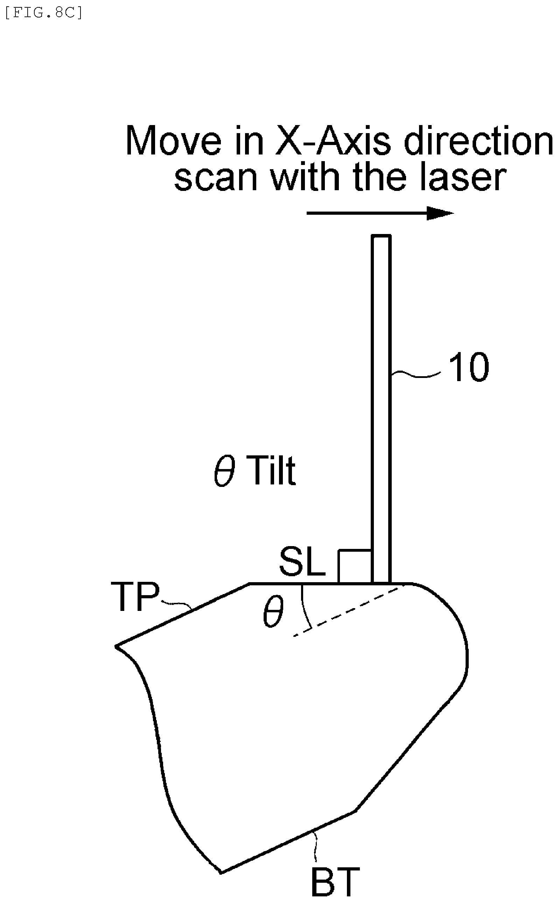

FIG. 8C is an enlarged view of the end (the area surrounded by the dashed line circle in the figure). As illustrated in the figure, to irradiate the slope SL, the workpiece moving stage 17 is rotated about the pitch axis so that the applied laser 10 and the slope SL are almost perpendicular to each other. Furthermore, the laser application is performed such that the wafer W is moved in the X-axis direction to be scanned.

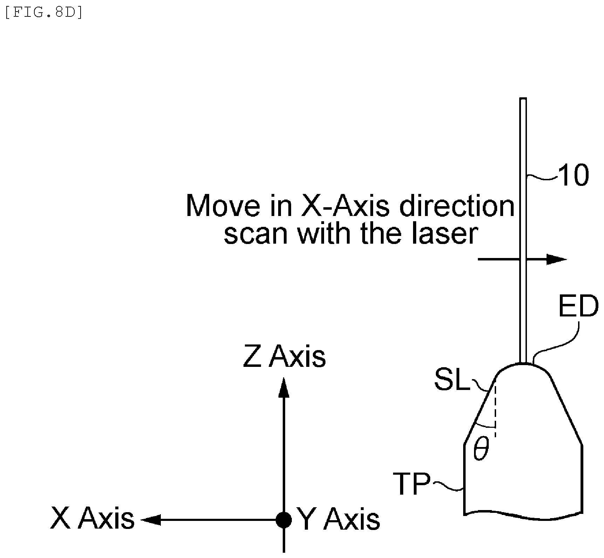

FIG. 8D is a diagram of an irradiation state by finishing of an end face ED. In the processing of the end face ED as well, the laser is applied such that the laser irradiation surface is perpendicular, as in FIG. 8C. Furthermore, the perimeter may be processed for one round by rotating the wafer W 360 degrees about the yaw axis.

Since the cut surface (the slope SL) by the laser 10 remains rough to some extent, (atmospheric pressure) water vapor plasma may be applied to the cut surface to form a uniform oxide film suitable for anisotropic etching or the like (alkaline etching such as NaOH) to be performed as a post-process, or polished in finishing.

Note that when the femtosecond laser application is set to the fluence at which ablation occurs, a nano-periodic structure is formed in a self-organized manner in a direction perpendicular to the polarization of the laser beam. The period of the nano-periodic structure varies with the fluence, the wavelength, and the number of incident pulses of the incident laser. In the case of the application of the femtosecond laser, s-polarization and p-polarization components may be adjusted by a polarizer.

Next, an example of a chamfering device capable of performing the chamfering will be described.

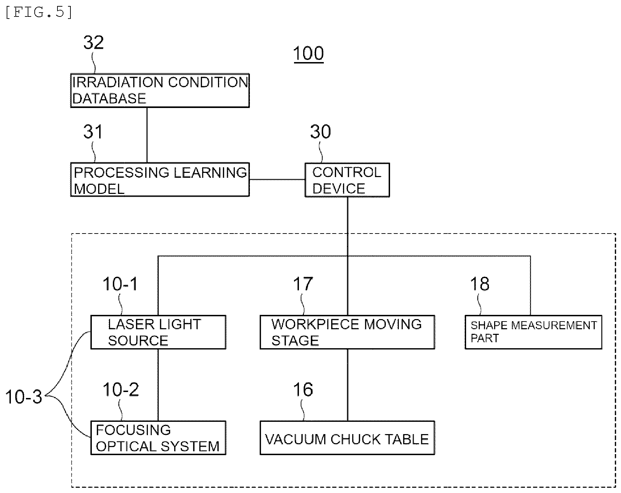

FIG. 5 is a functional block diagram of the chamfering device. This chamfering device 100 includes a control device 30, the workpiece moving stage 17, and the laser application part 10-3. Furthermore, the workpiece moving stage 17 includes the vacuum chuck table 16 holding the workpiece. The laser application part 10-3 includes the laser light source 10-1 and the focusing optical system 10-2. These hardware configurations have already been described.

The chamfering device 100 further includes a shape measurement part 18 measuring the shape and the like of the chamfer. The shape measurement part 18 measures the shape, waviness, roughness, and the like of the chamfer. The chamfering device 100 does not necessarily have to include the shape measurement part 18. The chamfering device 100 including the shape measurement part 18 is preferred in that it facilitates construction of a control model, which will be described below.

The control device 30, which is a computer including a processor and a memory (both are not shown), controls the parts with a computer program stored in the memory.

Specifically, the control device 30 loads the computer program into the memory by the processor and executes it to control the parts. The computer program can include an attitude control module by the five-axis control of the workpiece moving stage 17, a module for adjusting the laser intensity and the like applied by the laser application part 10-3, and the like.

In implementing the chamfering method described above, the control device 30, to execute the processing at Step S11 (preferably, furthermore, to execute Step S10), performs movement of the five axes of the workpiece moving stage 17 and controls the laser application part 10-3 to apply the laser 10 to the wafer W at a certain intensity and angle.

Specifically, to implement Step S10, movement of the five axes of the workpiece moving stage 17 is performed to adjust the relative attitude between the laser application part 10-3 and the wafer W so that the irradiation surface L to be perpendicular to the slope to be formed can be formed.

Furthermore, the laser application part 10-3 is controlled to apply the laser 10 at an intensity (laser application fluence) at which the irradiation surface L can be formed. If necessary, the laser 10 is applied at an intensity that amorphizes the irradiation surface L. Note that adjustment of the laser profile can be performed by adjusting the laser light source 10-1 and the focusing optical system 10-2.

Note that the control of the five axes of the workpiece moving stage 17 and the control of the laser application part 10-3 may be performed in sequence or performed simultaneously. As one form, they are preferably performed simultaneously.

The above also applies to the implementation of Step S11.

The chamfering device 100 can also commonly process a notch and an orientation flat shape, not limited to chamfering the perimeter of the wafer W.

Next, a method for constructing a control model to optimize parameters for controlling the workpiece moving stage 17, the laser application part 10-3, and the like will be described in detail.

First, the function of the constructed control model will be described. The chamfering device 100 includes an irradiation condition database 32 and a processing learning model 31 constructed using this database. These are stored in the memory of the control device 30. Note that if the processing learning model 31 that has already been constructed (machine learned) is stored in the memory of the control device 30, the chamfering device 100 does not necessarily have to include the irradiation condition database 32. The chamfering device 100 does not necessarily have to include the processing learning model 31, may include only the irradiation condition database 32, or may include neither of them.

The irradiation condition database 32 contains data containing a plurality of records in which the control parameters (laser output, pulse width, and the like) of the laser application part 10-3, the control parameters (a workpiece moving trajectory and the like) of the workpiece moving stage 17, the resulting pass/fail determination results about the shape of the wafer W, and the like (including the measurement result by the shape measurement part 18) are associated with each other.

The processing learning model 31 is a model constructed by machine learning with known algorithms based on the above data. The processing learning model 31 can determine the parameters of a control program to obtain the wafer W of a certain shape.

Specifically, the processing learning model 31 appropriately sets the control parameters of the laser application part 10-3 and the workpiece moving stage 17. Based on this, the control device 30 determines conditions for laser application (output, pulse width, and the like) and conditions for the movement of the wafer W, and controls the laser light source 10-1, the focusing optical system 10-2, the workpiece moving stage 17, the vacuum chuck table 16, the shape measurement part 18, and the like.

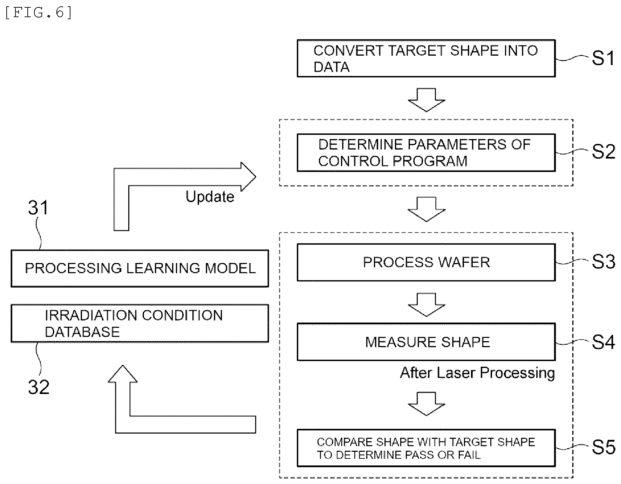

FIG. 6 is a flowchart of a method for constructing a control model for the chamfering method. First, the target shape of the chamfer is determined and the target shape is converted into data (Step S1).

Next, as Step S2, various parameters of the control program, that is, position control of the wafer W, and the pulse width of the laser, a condition for polarization for scanning the laser beam in a certain order with a polygon mirror or the like, a beam profile, a burst condition for outputting a waveform containing a designated number of cycles, and the like as an irradiation condition are determined in accordance with the target shape converted into data. Note that the setting of these parameters can be performed manually by the operator of the chamfering device 100.

As Step S3, processing of the wafer W is performed based on the set parameters.

Next, as Step S4, after the laser processing, the shape is measured by a camera including a charge coupled device (CCD) image sensor, a complementary metal-oxide semiconductor (CMOS) image sensor, or the like. The chamfer is imaged with an imaging plane by the camera made perpendicular by rotating the pitch axis with respect to the slope SL and the end face ED. Furthermore, the perimeter can be imaged for one round by rotating the yaw axis 360 degrees.

Next, the measurement result and the target shape are compared with each other to determine the pass or fail of it (Step S5).

The laser irradiation condition for each processing is recorded in the irradiation condition database 32 together with the pass/fail determination result. By using this irradiation condition database 32, the optimal condition (for example, polarization switching and pulse width adjustment) can be determined. By using this data set, the processing learning model 31 is created, by which the control program is updated, and the parameter setting at Step S2 can be automated.

Note that a waveplate and a polarizer are used to switch polarization. The waveplate and polarizer control, analyze, and optimize polarization and perform wavelength separation, fine tuning, ellipticity adjustment, polarization rotation, and the like for the laser light source 10-1.

As described above, the chamfering is performed by the laser 10 after the pre-processing to create in advance the irradiation surface L to be perpendicular to the slope SL, and thus processing quality can be improved. The embodiment is remarkable for its effects such as a reduction in a load on etching processing in the post-process, relatively clean processing that does not require any coolant or the like, using the laser, and a cost reduction owing to not requiring consumables such as grinding wheels.

Performing the chamfering with the laser 10 after performing the pre-processing to create in advance the irradiation surface L to be perpendicular to the slope SL is applicable not only to the wafer W made of 4H-SiC but also to any one using other polytypes (3C-SiC, 6H-SiC, 15R-SiC, and the like) and gallium nitride (GaN), gallium oxide, AlGaN, and diamond, which have a large band gap (UWBG) and are difficult-to-process materials.

### [Note 1.]

As described above, UWBG materials such as 4H-SiC are materials that are hard and difficult to process (difficult-to-process materials), and the conventional technologies described in JP 2004-111606 A and JP 2019-212761 A have had problems in that it takes time for processing, it is difficult to create desired shapes, and a reduction in grinding costs is not sufficient due to intense wear of grinding wheels.

The method of removing the corner of SiC wafers by applying laser ablation technology and then performing finishing with a grinding wheel has had problems in that when the area to be removed by the laser is large, increasing laser output causes thermal stress to cause cracks to propagate, debris is generated, and it is difficult to control removal shape (quality). Processing methods by the conventional technologies are all not realistic as a chamfering method for difficult-to-process materials in terms of time, quality, and price.

In the following, other solutions to the above problems will be disclosed. The above problems are, that is, to solve at least any of the problems of the conventional technologies. One of them is to provide a wafer chamfering method that can perform chamfering of the perimeter and the orientation flat (OF) of UWBG material wafers such as 4H-SiC, which are difficult-to-process materials, especially SiC wafers, using a laser, with suitable quality for post-processes such as polishing and a chamfering device for use in the chamfering method. Note that the suitable quality includes high-precision shape formation and uniform surface states (waviness and roughness).

A chamfering method of an embodiment 1A of the present disclosure is a chamfering method chamfering a perimeter of a wafer, the chamfering method applying a laser to an irradiation surface to be chamfered (a planned processed surface such as a slope) while changing a processing depth in a stepwise manner to cause non-thermal ablation and to remove an unnecessary part.

A chamfering method of an embodiment 2A of the present disclosure is the chamfering method according to the embodiment 1A, in which a scanning direction is made horizontal with respect to the slope to be chamfered, and a focal position of the laser is sequentially lowered toward the perimeter, and the number of irradiation passes in each step is increased in accordance with a removal amount.

A chamfering method of an embodiment 3A of the present disclosure is the chamfering method according to the embodiment 1A, in which the application of the laser is performed with a combination of at least two or more selected from the group consisting of:
(1) sequentially changing the focal position,
(2) changing the energy density in accordance with the removal amount,
(3) changing the number of irradiation passes in accordance with the removal amount, and
(4) changing a scanning speed in accordance with the removal amount.

A chamfering method of an embodiment 4A of the present disclosure is the chamfering method according to the embodiment 1A, in which the laser is a femtosecond laser, and a scan pitch with respect to a spot diameter of the laser (the scan pitch/the spot diameter) is 0.40 or more and 0.60 or less.

A chamfering method of an embodiment 5A of the present disclosure is the chamfering method according to any one of the embodiments 1A to 4A, in which the laser is a femtosecond laser with a wavelength of 515 nm or 532 nm, the spot diameter is 20 µm or more and 40 µm or less, and the scan pitch is 10 µm or more and 20 µm or less.

A chamfering method of an embodiment 6A of the present disclosure is the chamfering method according to any one of the embodiments 1A to 4A, in which a material of the wafer is SiC.

A chamfering method of an embodiment 7A of the present disclosure is the chamfering method according to any one of the embodiments 1A to 4A, in which a material of the wafer is any one selected from the group consisting of 4H-SiC, 3C-SiC, 6H-SiC, 15R-SiC, gallium nitride (GaN), gallium oxide, AlGaN, and diamond.

A chamfering method of an embodiment 8A of the present disclosure is the chamfering method according to the embodiment 5A, in which the unnecessary part is removed, and then laser annealing is performed with a picosecond or nanosecond pulsed laser with a wavelength of 515 nm or longer and 1,080 nm or shorter.

A chamfering device of an embodiment 1A of the present disclosure is a chamfering device chamfering a perimeter of a wafer, the chamfering device including a laser application part configured to apply a laser to the wafer, a workpiece moving stage configured to hold the wafer and having a structure with five axes including three axes of an X axis, a Y axis, and a Z axis and additional two axes of a yaw axis for rotation and a pitch axis for tilt, and a control device, in which the control device performs movement of the five axes with a computer program stored in advance, and controls the laser application part to apply the laser to an irradiation surface to be chamfered while changing a processing depth in a stepwise manner.

A chamfering device of the embodiment 2A of the present disclosure is the chamfering device according to the embodiment 1A, in which the control device controls the laser application part to cause non-thermal ablation in the irradiation surface and to remove an unnecessary part.

A chamfering device of the embodiment 3A of the present disclosure is the chamfering device according to the embodiment 1A or 2A, further including a shape measurement part measuring a shape of a chamfer, in which the control device includes a processing learning model machine-learned (constructed) with an irradiation condition database in which control parameters of the computer program and determination results based on measurement data of the wafer processed based on the control parameters by the shape measurement part are associated with each other.

A chamfering device of the embodiment 4A of the present disclosure is the chamfering device according to the embodiment 3A, in which the control device controls the laser application part and/or the workpiece moving table based on the control parameters created by the processing learning model.

The chamfering method according to the embodiments 1A to 8A and the chamfering device according to the embodiments 1A to 4A solve at least any of the problems of the conventional technologies. As a specific effect, chamfering of the perimeter and the orientation flat (OF) of UWBG material wafers such as 4H-SiC, which are difficult-to-process materials, especially SiC wafers can be performed using a laser, with suitable quality for post-processes such as polishing.

### [Second Example]

A chamfering device and a chamfering method will be described below with reference to the drawings.

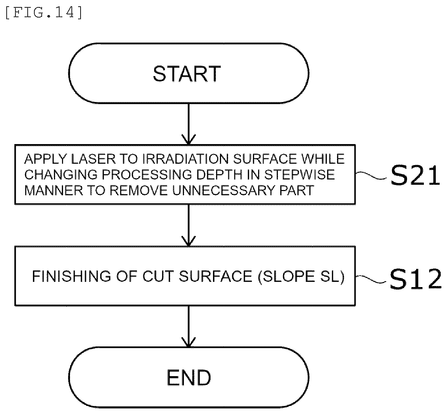

FIG. 14 is a flowchart of an example of the chamfering method. The chamfering method of the present example includes applying a laser to an irradiation surface to be chamfered (a planned processed surface, for example, the slope SL) while changing a processing depth in a stepwise manner to cause non-thermal ablation and to remove an unnecessary part (Step S21), and performing finishing of a cut surface (the slope SL as an example) (Step S12).

This example differs from the flow in FIG. 1C of the first example in that the surface to which the laser is applied is not the irradiation surface L, but the slope SL. Thus, it does not include Step S10 (the pre-processing to create in advance the irradiation surface L to be perpendicular to the slope (to be) formed by the chamfering) included in the flow in FIG. 1C.

Referring back to FIG. 14, as Step S21, a laser is applied to an irradiation surface to be chamfered (a slope) while changing a processing depth in a stepwise manner to cause non-thermal ablation and to remove an unnecessary part.

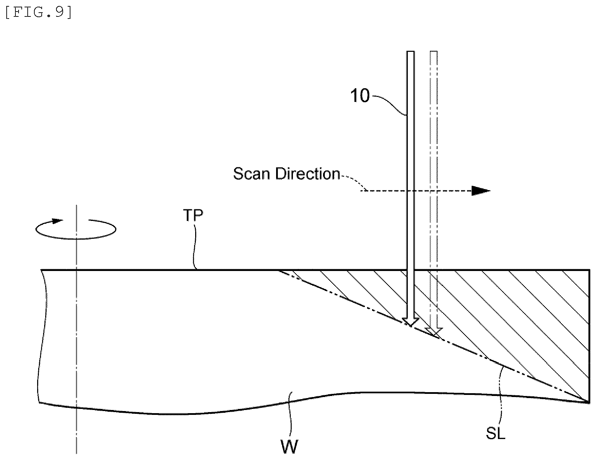

FIG. 9 is a diagram of an upper half section of the perimeter to be chamfered. The wafer W is rotating clockwise. The processing at Step S21 is performed by applying the laser 10 to the irradiation surface to be chamfered (the slope SL in FIG. 9) from above with a scanning direction made horizontal (while scanning in the direction indicated as "Scan Direction" in the figure) to cause ablation and to remove the hatched part in FIG. 9 (the part above the slope SL), which is the unnecessary part. The laser application is performed as non-thermal ablation with a pulsed laser with a pulse of nanoseconds, picoseconds, or femtoseconds, and is performed while changing the processing depth by changing the number of times of application or the like.

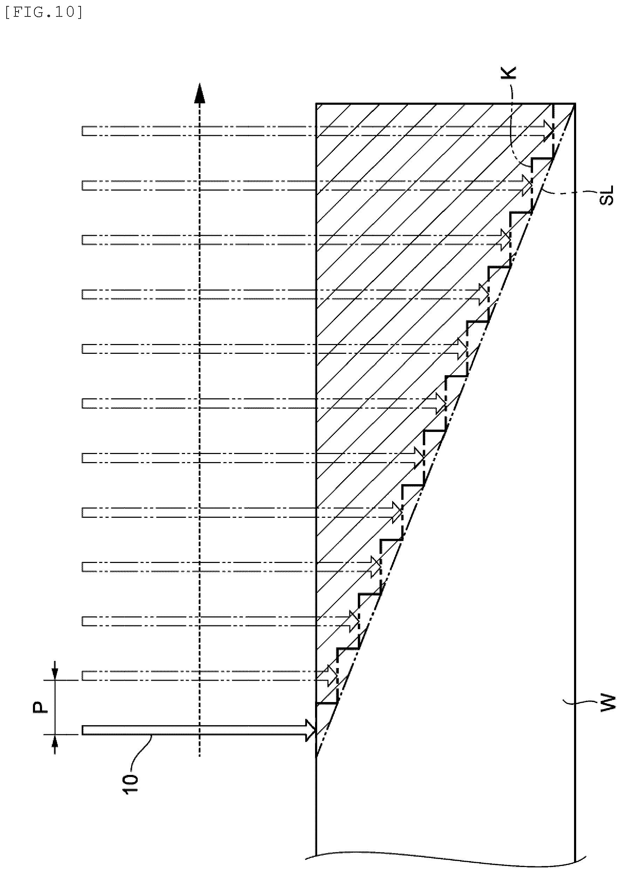

FIG. 10 is a sectional illustration of a state in which the laser 10 is being applied along the slope while changing its processing depth. As one form, the laser 10 is preferably a femtosecond laser.

The relation between the spot diameter (diameter: µm) of the laser and the scan pitch (the moving pitch of the spot: µm) is not limited to a particular relation, but in terms of producing a better effect, the scan pitch to the spot diameter (the scan pitch/the spot diameter) (µm/µm) is preferably 0.10 or more and 1.00 or less, more preferably 0.25 or more and 0.80 or less, even more preferably 0.40 or more and 0.60 or less, and as one form, particularly preferably almost 0.50.

Specifically, when the applied spot diameter is 20 µm or more and 40 µm or less, or 30 µm as an example, the scan pitch P is 10 µm or more and 20 µm or less, or 15 µm as an example. The wavelength of the laser 10 is preferably 515 nm or longer, 1,080 nm, or specifically, 515 nm, 532 nm, or the like.

At Step S21, removal of the unnecessary part of the wafer W by ablation is performed by applying the laser 10 to the irradiation surface to be chamfered (the slope SL) while changing the processing depth by stages or in a stepwise manner. Thus, the processed shape K is microscopically stepwise as illustrated in FIG. 10. Processing efficiency and processing quality are greatly affected by the polarization state and the pulse width of the laser 10.

The chamfer angle can be adjusted by the output and the number of times of scans of the laser 10. For example, when a processing time per step is made longer, the angle of the slope SL becomes larger. Furthermore, the processing amount per scan can be increased by increasing the output of the laser 10. It may be processed in a single scan or processed in a plurality of times of scans to a target shape (a target angle). When it is processed in a plurality of times of scans, processing quality easily improves. On the other hand, when it is processed in a single scan, the processing time is reduced more easily.

As to the control of the irradiation condition of the laser 10, for example, when the energy density per pulse is fixed, as illustrated in FIG. 10, the processing efficiency can be improved by operations such as sequentially lowering the focal position of the laser 10 as it moves toward the perimeter (the right direction in FIG. 10) and increasing the number of irradiation passes in each step in accordance with the removal amount.

The scanning direction of the laser 10 is a direction directed from the center of the wafer W to the perimeter ("Scan Direction" in FIG. 9, or the opposite is also possible), that is, a horizontal direction with respect to the irradiation surface to be chamfered. As it is scanned from the inside to the perimeter, the focal position is sequentially lowered in the vertical direction. Conversely, when it is scanned from the perimeter to the inside, the focal distance is sequentially raised in the vertical direction. A description of scanning in the reverse direction is the same, although it will be omitted below.

Furthermore, the number of irradiation passes is increased in accordance with the removal amount in accordance with scanning to the perimeter. As it is scanned toward the perimeter, the focal position is lowered vertically, and the amount (to be) removed increases accordingly. The above enables more efficient removal.

Note that since the removal amount is proportional to the energy density and the cumulative number of times of application (scanning speed) at the same point, the application of the laser 10 is preferably performed with a combination of changing the irradiation energy density or changing the scanning speed at the same height in addition to the above.

The focal position of the laser typically means a processing point, but the processing point, which is a point to be processed, and the focal position do not necessarily have to exactly match each other. The point to be processed may be positioned around the focal position.

Specifically, the application of the laser is preferably performed with a combination of at least two or more selected from the group consisting of (1) sequentially changing the focal position, (2) changing the energy density in accordance with the amount (to be) removed, (3) changing the number of irradiation passes in accordance with the removal amount, and (4) changing the scanning speed in accordance with the removal amount, and all these are preferably combined.

For example, as illustrated in FIG. 10, when the slope is performed while scanning from the inside to the perimeter of the wafer W, as it is scanned from the inside to the perimeter, it is preferable to perform at least two or more selected from: (1) moving the focal position vertically downward, (2) sequentially increasing the energy density, (3) increasing the number of irradiation passes, and (4) lowering the scanning speed. In particular, it is preferable to perform (1) and then perform any one or more of (2) to (4) in combination.

Referring back to FIG. 14, next, finishing is performed as Step S12. For the method of the finishing, a method similar to Step S12 in FIG. 1C can be used. Apart from the above, in the processing of the end, laser application by the same method as the chamfering can be used. This method will be described below.

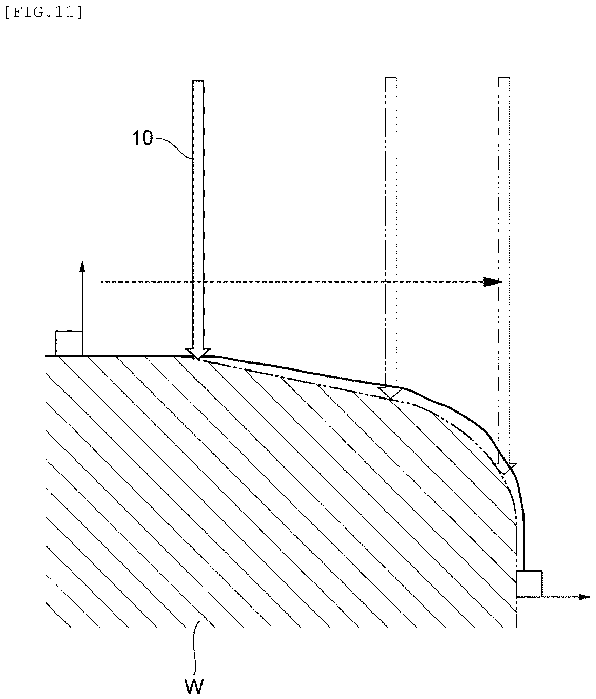

FIG. 11 is a sectional illustration of a method for applying the laser 10 to the end in the finishing or the like.

As described above, control of the irradiation condition of the laser 10 can be achieved by performing operations such as (1) sequentially changing the focal position, (2) changing the energy density in accordance with the removal amount, (3) changing the number of irradiation passes in accordance with the removal amount, and (4) changing the scanning speed in accordance with the removal amount in combination. This can improve processing quality in "chamfering of the notch," "partial" or "a small amount of" removal, and the like.

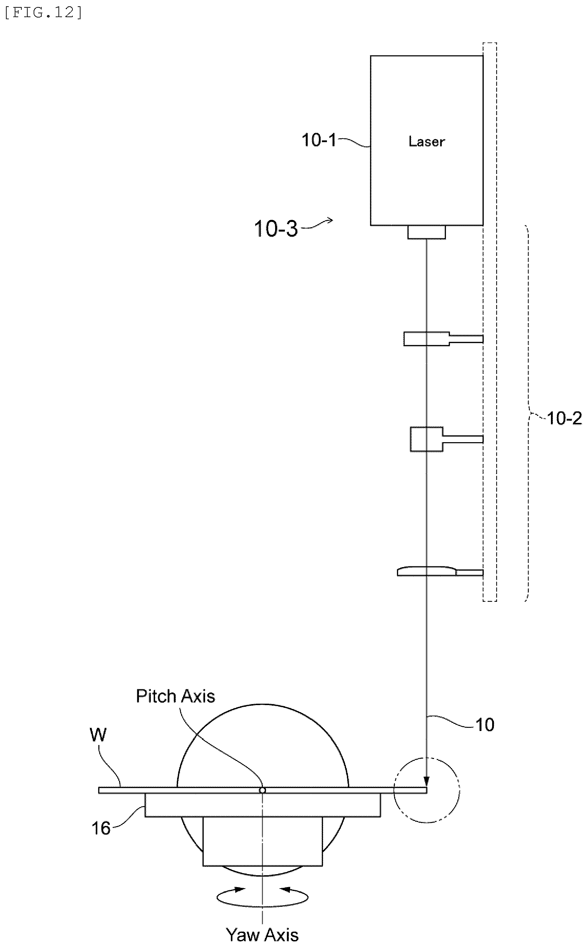

FIG. 12 is an example of a configuration diagram of the laser application part 10-3 in the implementation of the chamfering method of the present example. The hardware configuration of each part is as described above, and the system configuration of the chamfering device is the same as in FIG. 5.

For the outgoing light of the laser 10 from the laser light source 10-1 having a Gaussian beam profile, the diameter of the laser spot is caused to have a certain intensity and a certain spot diameter by a beam expander, which is the focusing optical system 10-2.

The chamfering is performed as non-thermal ablation in which a high-intensity, minute spot obtained by focusing the laser 10 by a focusing lens is applied to the wafer W to remove an unnecessary part. The non-thermal ablation directly breaks bonds in materials through light energy and can thus perform processing with less thermal effects than thermal processing.

The laser 10 is preferably applied with a femtosecond laser. The femtosecond laser is an optical laser emitting light for only a few femtoseconds to a few hundred femtoseconds, in which the time unit is treated in a "femto" (one quadrillionth) unit. The ablation process by the femtosecond laser is a non-thermal process in which after passing through a non-equilibrium state (two-temperature distribution) in which the electron temperature is sufficiently higher than the lattice ion temperature, heating of lattice ions starts after the application of the laser. The non-thermal process can reduce a heat-affected zone due to ablation and is processing by multiphoton absorption.

When the application of the femtosecond laser is set to the fluence at which ablation occurs, a nano-periodic structure is formed in a self-organized manner in a direction perpendicular to the polarization of the laser beam. The period of the nano-periodic structure varies with the fluence, the wavelength, and the number of incident pulses of the incident laser. In the case of the application of the femtosecond laser, s-polarization and p-polarization components may be adjusted by a polarizer.

For example, the femtosecond laser is applied to the chamfer to form the chamfered slope SL by non-thermal cutting (Step S21), and then annealing (crystallization and modification such as impurity removal) is performed with a picosecond or nanosecond pulsed laser with a wavelength of 515 nm or longer and 1,080 nm or shorter (515 nm or 532 nm as an example) (Step S12). Note that the irradiation surface may be amorphized as pre-processing for cutting.

When the irradiation surface is amorphized by laser application as the pre-processing, the laser is a single-shot nanosecond or picosecond pulsed laser with a wavelength λ of 515 nm or longer and 1,080 nm or shorter, with a lower intensity not higher than the processing threshold of SiC, which is the material of the wafer W. SiC has an inherent processing threshold, and with a nanosecond pulsed laser second with a specific condition (for example, within a range of 2 to 4 nanoseconds), the targeted part of the slope SL will be heated by absorption at an irradiation position of the laser, causing modification and making it a-Si (amorphous silicon).

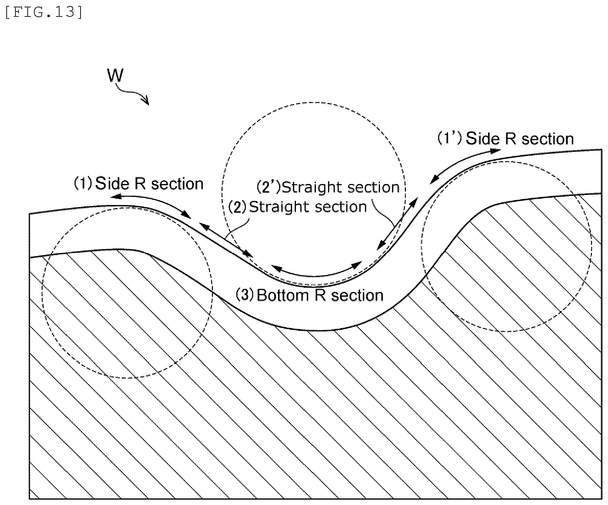

FIG. 13 is a sectional view of the shape of the notch of wafer W. The notch shape is a complex three-dimensional shape, and its irradiation sections continue from the left end in FIG. 13 as (1) a side R section, (2) a straight section, (3) a bottom R section, (2') a straight section, which differs from (2) the straight section in a sloping direction, and (1') a side R section, which is symmetrical with (1) the side R section. The sectional shape includes an end face perpendicular to the top surface TP or the bottom surface BT of the wafer W, two R sections connected to both ends of the end face, and two slopes SL connected to the two respective R sections (FIG. 8A).

Laser application to the notch is performed at each irradiation section of the complex three-dimensional shape illustrated in FIG. 13 and is configured as uniform, high-speed laser heating processing by using optical elements and actuators. For example, the focusing optical system 10-2 applying the laser 10 to the notch from the laser light source 10-1 includes a polygon mirror reflecting the laser 10 and a focusing lens focusing the reflected laser 10 to the notch, and by rotating the polygon mirror, the laser 10 is scanned and applied to the notch.

Uniform surface treatment of the notch is achieved by continuous (without breaks in a treated part) and constant velocity laser scanning (if this is difficult, the laser irradiation energy is appropriately adjusted for the velocity change) of the entire notch and laser application for a shape change. High-speed surface treatment is preferably performed by avoiding movement of the wafer W during laser application as much as possible. The laser application is performed almost perpendicularly to the treated surface (the irradiation surface) (the incident angle is preferably 0 to 15°, and more preferably 0°). Furthermore, the irradiation condition is determined in response to crystal orientation and shape.

The chamfering method of the present example can be achieved by the chamfering device illustrated in FIG. 5. In this case, the computer program stored in the memory of the control device 30 is different from the implementation of the flow in the first example (FIG. 1C). Specifically, the control method and/or parameters of the laser application part 10-3 and/or the workpiece moving stage 17 are different from those in the first example.

Specifically, the computer program is different in that it performs movement of the five axes of the workpiece moving stage 17 and controls the laser application part 10-3 to apply the laser to the irradiation surface to be chamfered (the slope SL in the present example) while changing a processing depth in a stepwise manner.

Note that the control device 30 may include an irradiation condition database in which the control parameters of the computer program and pass/fail determination results based on the measurement data of the wafer processed based on the control parameters by the shape measurement part are associated with each other and a processing learning model that has been machine-learned (constructed) thereby and may be configured to control the laser application part and the workpiece moving table by them.

These details are the same as those of each function of the chamfering device of the first example, and thus descriptions thereof are omitted.

As described above, according to the chamfering method of the present example, the femtosecond laser is applied to the chamfer to perform cutting by non-thermal processing, and then the laser annealing is performed, and thus the processing quality can be improved. The embodiment is remarkable for its effects such as a reduction in a load on etching processing in the post-process, relatively clean processing that does not require any coolant or the like, and a cost reduction owing to not requiring consumables such as grinding wheels.

One embodiment is applicable not only to the wafer W made of 4H-SiC but also to any one using other polytypes (3C-SiC, 6H-SiC, 15R-SiC, and the like) and GaN (gallium nitride), gallium oxide, AlGaN, and diamond, which have a large band gap (UWBG) and are difficult-to-process materials.

### [Note 2.]

Conventionally, methods and devices chamfering an end (a peripheral edge) of semiconductor wafers by laser application have been known.

When the method described in JP 2004-111606 A, which has already been illustrated, is attempted to be applied to difficult-to-process materials such as compound semiconductor wafers, the quality of laser processing may be insufficient depending on the target shape of the end, especially in shaping a slope part.

Thus, it is also an object of the present disclosure to provide a chamfering device that can achieve high-quality chamfering with a simple mechanism even when compound semiconductor wafers are targeted. It is also an object to provide a chamfering method.

A chamfering device of an embodiment 1B of the present disclosure is a chamfering device chamfering an end of a compound semiconductor wafer with laser application, the chamfering device including at least one optical system applying a laser to the end each from a normal direction in which a principal surface of the compound semiconductor wafer faces and a parallel direction along the principal surface, a moving mechanism moving an irradiation position of the laser at the compound semiconductor wafer, and a control device, a modified layer being formed at the irradiation position by a first laser incident from either the normal direction or the parallel direction, the modified layer being heated and the compound semiconductor wafer being cut by a second laser made incident on the modified layer at the irradiation position from the other, and the control device controlling the moving mechanism such that the irradiation position is scanned along a planned chamfer line of the end.

A chamfering device of an embodiment 2B of the present disclosure is the chamfering device according to the embodiment 1B, in which the at least one optical system includes two optical systems disposed apart from the compound semiconductor wafer in the normal direction and the parallel direction each, and one of the two optical systems applies the first laser and the other applies the second laser.

A chamfering device of an embodiment 3B of the present disclosure is the chamfering device according to the embodiment 2B, in which the planned chamfer line includes a part sloping from the principal surface toward a side surface.

A chamfering device of an embodiment 4B of the present disclosure is the chamfering device according to any one of the embodiments 1B to 3B, in which the moving mechanism moves at least one selected from the group consisting of the compound semiconductor wafer and the optical system to move the irradiation position.

A chamfering device of an embodiment 5B of the present disclosure is the chamfering device according to the embodiment 2B, including a reflector for changing an irradiation direction of the at least one laser of the two optical systems, and the two optical systems are each disposed in the same direction selected from the group consisting of the normal direction and the parallel direction apart from the compound semiconductor wafer.

A chamfering device of an embodiment 6B of the present disclosure is the chamfering device according to the embodiment 1B or 2B, in which the moving mechanism can rotate the compound semiconductor wafer, and the optical system applying the second laser is disposed in front of the optical system applying the first laser in a rotation direction of the compound semiconductor wafer.

A chamfering device of an embodiment 7B of the present disclosure is the chamfering device according to the embodiment 1B or 2B, in which the control device controls the moving mechanism such that an incident angle of the laser incident from the parallel direction, the incident angle with respect to an end face of the compound semiconductor wafer being 0 to 15 deg. Note that "to" means a numerical range including the values before and after it.

A chamfering device of an embodiment 8B of the present disclosure is the chamfering device according to the embodiment 1B or 2B, in which the at least one optical system includes an optical system that can emit a third laser for annealing to adjust the surface of the compound semiconductor wafer after cutting.

A chamfering method of the embodiment 1B of the present disclosure is a chamfering method chamfering an end of a compound semiconductor wafer by laser application, the chamfering method including applying a first laser such that a modified layer is formed at an irradiation position from either a normal direction in which a principal surface of the compound semiconductor wafer faces or a parallel direction along the principal surface, and applying a second laser to the formed modified layer from the other to heat the modified layer and to cut the compound semiconductor wafer, the irradiation position being scanned along a planned chamfer line of the end.

### [Third Example]

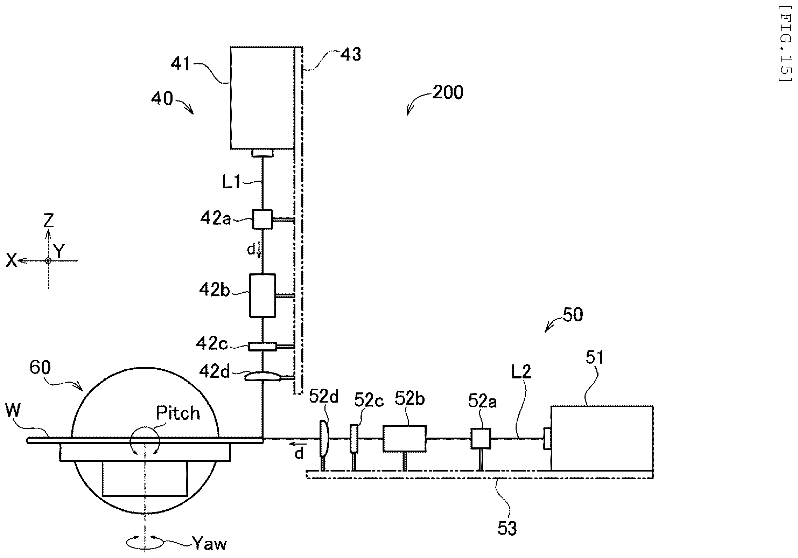

An example of the chamfering device will be described based on the drawings. FIG. 15 is an illustration of a main part of the chamfering device. Note that FIG. 15 is a Y-axis front view. FIG. 15 is a diagram for illustrating the relation between the wafer W, which is a compound semiconductor wafer, and an optical system. In FIG. 15, other configurations that the chamfering device has are omitted.

This chamfering device 200 includes a first optical system 40 applying a first laser L1 to an end of the wafer W from a direction in which its principal surface faces (a normal direction) (along the normal direction), a second optical system 50 applying a second laser L2 to its end from a direction along the principal surface of the wafer W (a parallel direction) (in parallel to the principal surface), and a wafer holding device 60 holding the wafer W. Note that the arrow d in the figure represents the travel direction (application direction) of the laser, and this also applies to the following figures.

The first optical system 40 includes a base board 43, a laser light source 41 fixed to the base board 43, and an optical element group disposed on an optical axis. The optical element group adjusts the spot shape, the energy density distribution, the focal point, and the like of the laser emitted from the laser light source 41. The chamfering device 200 includes a beam splitter 42a, a beam expander 42b, a mask 42c, and a focusing lens 42d as the optical element group in order from the laser light source 41.

Note that the above is a basic configuration of the optical system. The first optical system 40 may further include optical elements with other functions (for example, reflectors such as mirrors, homogenizers, and the like) to the extent that they produce desired effects. In addition, the optical system does not necessarily have to include any one or more of the above optical elements.

The first laser L1 is output from laser light source 41. The first laser L1 forms a modified layer on the end face of the wafer W. The medium, the oscillation type, and the output wavelength of the first laser L1 are not limited to particular ones. They may be selected as appropriate in accordance with the type of the wafer W.

For example, the oscillation type is preferably a pulsed laser and/or a continuous (CW) laser. In particular, when the pulsed laser and the CW laser are used together, the modified layer is likely to be formed more efficiently. The time duration of the pulse is not limited to a particular time duration, but is preferably about picoseconds to nanoseconds.

The wavelength of the first laser L1 is selected in accordance with the material of the wafer W. The wavelength is preferably a wavelength having transparency to the wafer W. For example, when the wafer W is a SiC substrate, the wavelength λ is preferably 500 nm or longer, and more preferably 515 nm or longer. One form may be 800 nm or longer. The upper limit thereof is not limited to a particular wavelength, but is preferably 1,080 nm or shorter, and more preferably 1,064 nm or shorter. In other words, preferred are 500 to 1,080 nm, 515 to 1,080 nm, 800 to 1,080 nm, 500 to 1,064 nm, 515 to 1,064 nm, and 800 to 1,064 nm.

As one form, the first laser L1 is preferably a picosecond to nanosecond pulsed laser with a wavelength of 515 to 1,080 nm.

The first laser L1 acts on the primary structure of molecules that make up the wafer W and modifies it. Meanwhile, it is preferably strong enough to inhibit the occurrence of ablation.

Thus, the irradiation condition of the first laser L1 is preferably determined in accordance with the crystal orientation and shape so that the cumulative value of laser irradiation energy (cumulative irradiation energy) to the irradiation position is not higher than the processing threshold of the material of the wafer W.

This further inhibits abrupt temperature changes, reduces a load due to repetitive thermal stress, and further inhibits the occurrence of dislocations.

Examples of the modified layer to be formed when the wafer W is a SiC substrate include a layer in which at least part of it is amorphous Si (a-Si).

The SiC substrate has high hardness and has generally been considered a difficult-to-process material. Chamfering with a grinding wheel has had problems in that it takes long time for chamfering and the life of the griding wheel is shortened. The method of removing a corner by laser ablation has been considered difficult because it takes a long time to remove a large portion (a large area) of a workpiece, thermal stress causes unintended cracks to propagate, and debris is generated.

In the chamfering device of the present example, after forming the modified layer by the first laser L1 the cumulative value of energy of which is adjusted to be not higher than the processing threshold, the wafer W is cut from the modified layer by applying the second laser L2 the effect on the modified layer of which is specific. Thus, the above problems are even less likely to occur. Furthermore, both the first laser L1 and the second laser L2, which will be described below, are applied such that the incident angle is almost 0 deg with respect to the principal surface or the side surface, thus making laser scattering even less likely to occur and also making it easier to inhibit the occurrence of the focal point at an unintended place. This is more effective especially when the wafer W is unprocessed and a thin, cylindrical shape. When such an unprocessed wafer W is attempted to be chamfered with a grinding wheel, the life of the grinding wheel tends to be shortened. This tendency is more pronounced when the wafer W is a difficult-to-process material such as SiC.

In addition, the chamfering device of the present example can further simultaneously apply the first laser and the second laser each from the normal direction to the principal surface and the parallel direction to the principal surface, thus providing excellent processing speed.

An example of a method of applying the first laser L1 in the case of a SiC substrate will be described.

The picosecond to nanosecond pulsed laser of the first laser L1 has a single shot with a wavelength of λ = 515 nm to 1,080 nm and a low intensity not higher than the processing threshold of the SiC substrate. The fluence (photon density: energy per unit area) of the nanosecond pulsed laser is made lower than the fluence (photon density) at which laser ablation occurs. SiC has an inherent processing threshold, with the nanosecond pulsed laser with a specific condition, modification occurs at the irradiation position (the focal point), making it a-Si (amorphous silicon).

The irradiation position of the first laser is preferably located on the planned chamfer line of the wafer W. In this case, the irradiation position of the first laser is almost the same as the focal point of the first laser. The first laser is applied for the purpose of forming the modified layer. Thus, when the irradiation position (the focal point) is narrowed down and adjusted to form the modified layer in a narrower area, the wafer W after processing with a higher similarity to a target shape can be obtained.

On the other hand, since the second laser, which will be described below, uses a laser with a wavelength the effect on the modified layer of which is specific, it is easy to obtain a good result even if the irradiation position is not strictly narrowed down on the planned chamfer line (it may be narrowed down). In other words, if the modified layer can be heated, the focal point does not necessarily have to be located on the planned chamfer line. The modified layer may be included as the irradiation position.

Thus, there is a difference in the preferred form of narrowing down the irradiation range between the first laser and the second laser. However, in the following description, for convenience, the irradiation position and the focal point are used as having synonymy. The difference in the irradiation range between the first laser and the second laser is not represented in the figure, but is shown as a similar one. However, the details are as the above.

Note that changing of the spot shape and the laser profile such as energy density distribution of the first laser L1 are adjusted by each optical element. In addition, its focal point is adjusted to be a desired position (the irradiation position) of the wafer W. Note that the incident angle of the first laser L1 with respect to the principal surface of the wafer W is adjusted to be 0 to 15 deg, and is preferably almost 0 deg. The incident angle being 0 deg means that the angle between the travel direction of the first laser L1 and the principal surface is 90 deg. When the incident angle is within the above range, the absorption rate increases, and the processing efficiency is likely to increase. The adjustment is performed by a moving mechanism described below.

When the incident angle is adjusted to almost 0 deg (preferably 0 deg), unintended scattering of the first laser L1 on the wafer surface (the principal surface) is more unlikely to occur. In addition, ablation caused by light being focused on an unintended place is inhibited, and thus the occurrence of particles is further inhibited. As a result, chamfering with higher quality is made possible.

The laser light source 41 and the optical element group are fixed on the base board 43 fixed in place. Note that the base board 43 may be configured to be translatable in the X-, Y-, and Z-axis directions. It may also be configured to be tiltable about the pitch axis. When the base board 43 is configured to be translatable and/or tiltable, the moving mechanism is configured together with a base board 53 of the second optical system 50 and the wafer holding device 60, which will be described below.

The second optical system 50 applies the second laser L2 to the end of the wafer W from a direction along its principal surface. The second optical system 50 includes a laser light source 51, an optical element group (a beam splitter 52a, a beam expander 52b, a mask 52c, and a focusing lens 52d), and the base board 53 to which these are fixed. The basic configuration is the same as that of the first optical system 40.

The second laser L2 output from laser light source 51 acts on the modified layer, typically heating it locally. The wafer W is cut at the irradiation position (the modified layer).

The applied second laser L2 is preferably a laser with a wavelength that is easily absorbed by the modified layer (the amorphous layer). When the second laser L2 is more easily absorbed by the modified layer, the effect on the part other than the modified layer can be further controlled, and the processing quality further improves.

As one form, the second laser L2 is a high fluence laser beam, and the modified layer at the irradiation position (the focal point) is instantaneously melted and evaporated, releasing ions, atoms, radicals, molecules, clusters, solid fragments, and the like. This is performed in a fast process.

For example, it has been described that when the material of the wafer W is SiC, the modified layer is the a-Si layer. This a-Si layer has strong absorption to light with a wavelength of 532 nm. Thus, the second laser L2 preferably includes a laser with a wavelength of 532 nm. Picosecond to nanosecond pulsed lasers with an energy per pulse width of 0.5 to 150 µJ and an energy density of 0.125 to 22 J/cm² are preferred.

The nanosecond pulsed laser of the second laser L2 melts the a-Si layer of the modified layer formed by the first laser L1 at nanosecond speed.

Note that the processing threshold varies depending on the material of the wafer W. The fluence varies depending on the wavelength, intensity, pulse width, repetition frequency, and the like of the laser and may be selected as appropriate in accordance with the material.

Note that the wafer W that can be processed in the chamfering device of the present example is a compound semiconductor wafer, and there is no particular limitation on its material. Examples of the material include ZnSe as a Group II-Group VI semiconductor; GaAs, GaN, InP, InGaAlP, and InGaN as Group III-Group V semiconductors; and SiC and SiGe as Group IV-Group IV semiconductors. Among these, Group III-Group V semiconductors and Group IV-Group IV semiconductors are preferred, and group IV-Group IV semiconductors are more preferred.

Examples of silicon carbide (SiC) include 2H-SiC, 3C-SiC, 4H-SiC, and 6H-SiC.

The wafer W is fixed to the wafer holding device 60. The wafer holding device 60 holds the wafer W by a vacuum chuck system. The wafer holding device 60 can rotate the wafer W about the yaw axis. The wafer holding device 60 is translatable with respect to each of the X axis, the Y axis, and the Z axis and is rotatable about the pitch axis.

The wafer holding device 60 moves the wafer W and changes its relative position with the two optical systems. This enables the irradiation position of the laser to be moved to any position on the wafer W.

The optical systems may be configured to be movable together with or instead of the wafer holding device 60. The moving mechanism of the chamfering device includes the operating wafer holding device 60 and/or the operating optical systems.

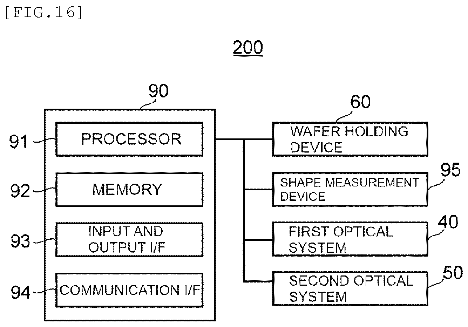

FIG. 16 is a hardware configuration diagram of the chamfering device 200 of the present example. The chamfering device 200 includes the wafer holding device 60, the first optical system 40, the second optical system 50, a shape measurement device 95, and a control device 90. The control device 90 is a computer including a processor 91, a memory 92, an input and output interface (I/F) 93, and a communication I/F 94. The control device 90 is connected to the parts such that they can mutually send and receive data.

The control device 90 is the controller of the chamfering device 200.

The processor 91 is, for example, a microprocessor, a processor core, a multiprocessor, an application-specific integrated circuit (ASIC), a field programmable gate array (FPGA), a general-purpose computing on graphics processing unit (GPGPU), or the like.

The memory 92 has a function of storing various computer programs and data temporarily and/or non-temporarily, and provides a working area for the processor.

The memory 92 is, for example, a read only memory (ROM), a random access memory (RAM), a hard disk drive (HDD), a flash memory, a solid state drive (SSD), or the like.

Various input and output devices and the like are connected to the input and output I/F 93. The wafer holding device 60, the shape measurement device 95, the first optical system 40, and the second optical system 50 may also be connected via the input and output I/F 93.

The input device (not shown) connected to the control device 90 via the input and output I/F 93 is a device for various information input and for receiving input of instructions to the chamfering device 200. The input device may be a keyboard, a mouse, a scanner, a touch panel, or the like.

The output device (not shown) connected to the chamfering device 200 via the input and output I/F 93 is a device for outputting the status of the chamfering device 200, various results, and the like. The output device may be a liquid crystal display, an organic electro luminescence (EL) display, or the like.

The output device may be configured integrally with the input device. This case includes a form in which the output device is a touch panel providing a graphical user interface (GUI).

The control device 90 is connected to a computer network such as the Internet, a wide area network, and a local area network via the communication I/F 94. The wafer holding device 60, the shape measurement device 95, the first optical system 40, and the second optical system 50 may be connected to the control device 90 via the communication I/F 94 (in other words, via the computer network).

The control device 90 may receive input data of various information and/or transmit output data via the communication I/F 94 regardless of whether the presence or absence of the input device and/or the output device.

The shape measurement device 95 is a device for measuring the shape of the wafer W to acquire shape data. As the shape measurement device 95, known shape measurement devices of the white interference system and of the laser confocal system can be used. In addition, imaging devices such as CCDs and CMOSs can also be used.

The shape measurement device 95 can rotate the pitch axis with respect to the end (the slope and the side surface) to image the side surface. Furthermore, by rotating the yaw axis 360 degrees and imaging one round, the perimeter shape can also be imaged. A combination of these can generate the shape data.

The shape data acquired by the shape measurement device 95 includes at least a shape corresponding to a target shape. The target shape can usually be set by the user (operator) of the device.

Note that the shape measurement device 95 only needs to acquire the shape data including the shape (edge shape) of one or more certain ends of the wafer W; it is preferable to acquire the shape data over the entire perimeter.

Note that the "shape corresponding to the target shape" means a shape for which the difference from the target shape can be calculated and/or examined by comparison with the target shape. The shape data means data that can be contrasted with the data constituting the target shape.

As an example, the shape data includes the angle of the slope of the wafer W, the curvature of the R section, and the thickness (height) of the outermost end (the side surface).

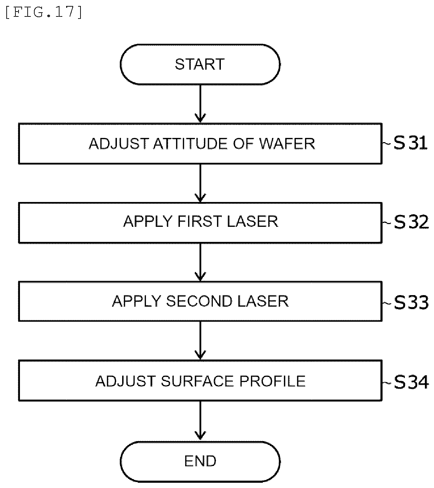

FIG. 17 is a flow diagram of the chamfering of the wafer W by the chamfering device 200. The chamfering method first includes a step of adjusting the attitude of the wafer W as Step S31.

The step of adjusting the attitude of the wafer W is, in other words, a step of adjusting the irradiation positions of the first laser L1 and the second laser L2 on the wafer W. Specifically, the positional relation between the wafer W and the two optical systems is adjusted by the wafer holding device 60 (and/or the movable optical system), and the irradiation positions of the lasers are adjusted.

The irradiation position is determined in accordance with the target shape of the wafer W after processing. After passing through the latter step, the wafer W is cut from the irradiation position. Thus, the irradiation position is determined in accordance with the planned chamfer line of the wafer W. By scanning the irradiation position along the planned chamfer line, the wafer W is chamfered.

Note that the planned chamfer line preferably includes a part sloping from the principal surface toward the side surface (an outer surface). One of the features of the chamfering device 200 is that the laser is applied at an incident angle of almost 0 deg with respect to the principal surface and the side surface each. In other words, one of the features is that the laser is applied at an angle in which its travel direction is almost perpendicular to the principal surface and the side surface each.

Even when the planned chamfer line includes a sloping part (in other words, even when the shape after chamfering is a slope), it is not necessary to apply the laser to the principal surface or the side surface obliquely (at a large incident angle). By simply adjusting the movement trajectory of the wafer W (without changing the incident angle), the wafer W can be obliquely cut to form a slope on the end. In the chamfering device 200, the laser is applied to the principal surface and the side surface of the wafer W before chamfering (typically disk-shaped, with rectangular cut end face in the diametrical direction) at a smaller (almost 0 deg) incident angle, and thus unintended scattering and ablation are less likely to occur. As a result, chamfering with higher quality is made possible.

Next, the first laser for modification is applied to the irradiation position (Step S32). When the first laser is applied, a modified layer is formed at the irradiation position. Next, the second laser is applied to the modified layer at the irradiation position (Step S33). When the second laser is applied, the modified layer is heated and the wafer W is cut.

The above Steps S31 to S33 may be performed concurrently.

For example, the irradiation positions of the first laser and the second lasers may be made the same position, and the first laser (Step S32) and the second laser (Step S33) may be simultaneously applied while moving the irradiation positions so as to scan them along the planned chamfer line (Step S31).

The irradiation position of the first laser and the irradiation position of the second laser may be different from each other. The second laser may be applied to the modified layer formed by the application of the first laser at a new irradiation position.

Next, as Step S34, the surface profile of the wafer W is adjusted. The method of adjustment is not limited to a particular method, but it is preferable that the surface be annealed by laser application to flatten or mirror the surface. The method for adjusting the surface profile will be described below.

Next, the operation of the chamfering device 200 during chamfering by laser application will be described.

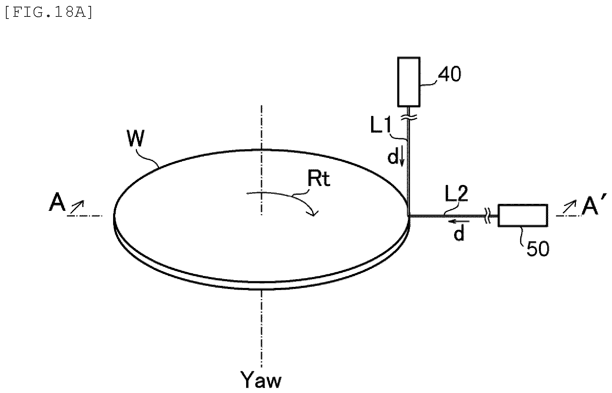

FIG. 18A to FIG. 18C are illustrations of the positional relation among the wafer W, the first laser, and the second laser at Steps S31 to S33 described above.

FIG. 18A is a diagram of a positional relation when the first laser is applied from the normal direction and the second laser is applied from the parallel direction to the wafer W rotating in an Rt direction about the yaw axis. The first laser and the second laser are simultaneously applied to the same position (one irradiation position) on the end.

The first laser is applied from the normal direction, almost perpendicular to the principal surface (at an incident angle of about 0 deg). On the other hand, the second laser is applied from the parallel direction, almost perpendicular to the side surface (at an incident angle of about 0 deg).

The wafer W rotates in the Rt direction about the yaw axis passing through the center of the principal surface.

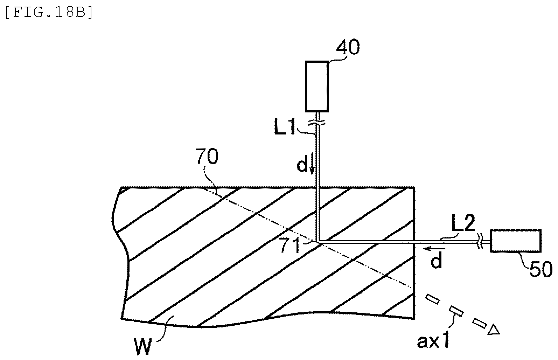

FIG. 18B is a partial sectional view of the wafer end at the A-A' line. Note that the sections of the first laser L1, the second laser L2, the first optical system 40, and the second optical system 50 are omitted for convenience of description (the same applies below).

The cut end face of the end of the wafer W before chamfering at the A-A' line is, schematically speaking, rectangular. Of these, FIG. 18B is a diagram representing a case in which the corner is obliquely cut off to form a slope leading to the side surface (the outer surface) from the principal surface. When it is cut in accordance with a planned chamfer line 70, the slope of the wafer W is formed.

The first laser L1 and the second laser L2 are applied to the same place (an irradiation position 71) on the planned chamfer line 70. At the irradiation position 71, the first laser forms a modified layer. The second laser applied simultaneously heats the formed modified layer and cuts the wafer W.

When the wafer W is rotated in the Rt direction, it is cut over one round of the wafer W.

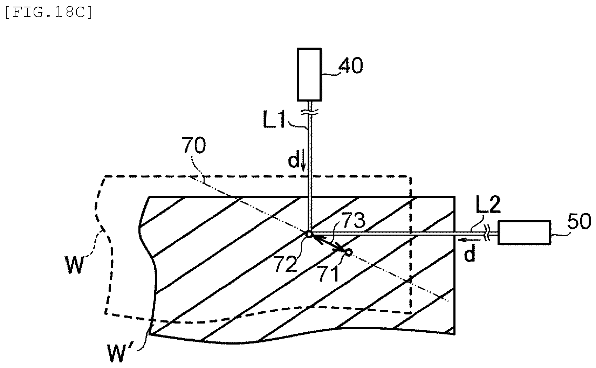

FIG. 18C is a diagram of a state (a wafer W') in which the wafer W has been moved in a direction ax1 by the moving mechanism. At this time, the wafer W is cut in the same way as described above at an irradiation position 72. When the wafer W rotates in the Rt direction, the wafer W is cut over the entire perimeter thereof.

A distance 73 between the two irradiation positions 71 and 72 depends on the movement pitch of the wafer W in the direction ax1. In FIG. 18A and FIG. 18B, the pitch is illustrated larger for illustration. In practice, the pitch length is preferably adjusted such that cut lines formed by irradiation can be connected to each other to form a cut surface. The pitch length can be adjusted as appropriate depending on the material of the wafer W and the like. For example, as one form, the pitch length is preferably in a range of 0.3 to 1.8 when the spot diameter of the first laser is set to 1. The diameter of the first laser affects the size of the modified layer to be formed. Thus, when the pitch length is such that the modified layer is almost continuous, it is easier to perform chamfering more efficiently.

Note that in FIG. 18A to FIG. 18C, the first laser L1 is applied from the normal direction and the second laser L2 is applied from the parallel direction. However, the first laser L1 may be applied from the parallel direction and the second laser L2 may be applied. The first laser L1 may be applied from vertically below the wafer W. The first laser L1 may be applied, and then the second laser L2 may be applied to the same position by one optical system.

When configured as in FIG. 18A to FIG. 18C, when the modified layer is formed by the first laser L1, the output of the laser is set to not higher than the processing threshold, and thus ablation or the like is unlikely to occur. Furthermore, since the effect of the second laser L2 is specific by the modified layer, unintended cracks or the like are unlikely to occur. Thus, compared to the case in which modification and cutting are performed by one type of laser, the generation of debris or the like is inhibited, and high-quality chamfering is made possible.

Furthermore, since they are applied from two directions, there is leeway in the deposition of the optical system, making a device layout easier.

In addition, since the lasers are made incident on the principal surface and the side surface each at an incident angle of almost 0 deg, scattering of the laser and formation of the focal point at an unintended position are inhibited even when forming the slope, and excellent processing quality is obtained.

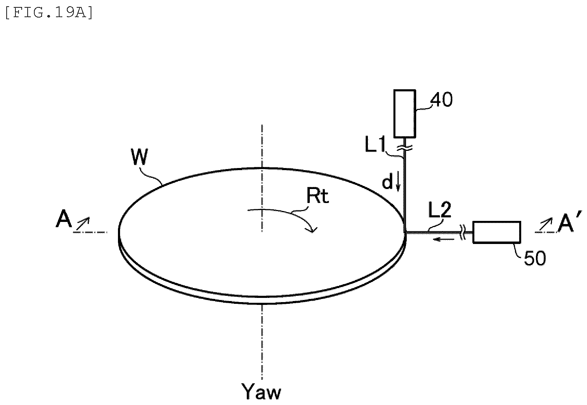

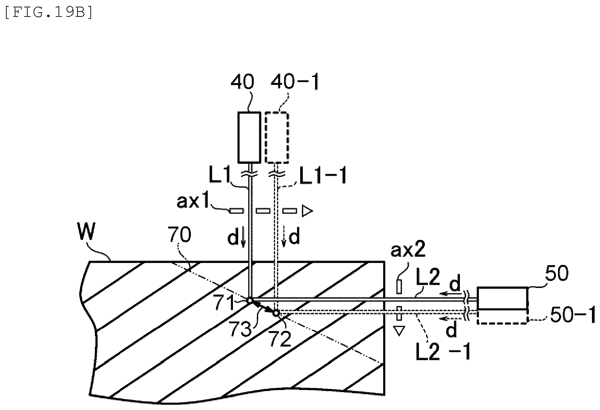

FIG. 19A and FIG. 19B are illustrations of a first modification of the method for adjusting the irradiation position. In the form in FIG. 19A and FIG. 19B, the first optical system 40 applying the first laser L1 and the second optical system 50 applying the second laser L2 are moved to move the irradiation position. FIG. 19A is a diagram of a positional relation when the first laser L1 is applied from the normal direction and the second laser L2 is applied from the parallel direction to the wafer W rotating in the Rt direction about the yaw axis. The first laser L1 and the second laser L2 are simultaneously applied to the same position (one irradiation position) on the end.

FIG. 19B is a partial sectional view of the wafer end at the A-A' line. As in FIG. 18B, this figure represents a case in which the corner is obliquely cut off to form a slope to the side surface (the outer surface) from the principal surface. That is, when it is cut in accordance with the planned chamfer line 70, the slope of the wafer W is formed.

The first laser L1 and the second laser L2 are applied to the same place (the irradiation position 71) on the planned chamfer line 70. At the irradiation position 71, the first laser L1 forms a modified layer. The second laser L2 applied simultaneously heats the formed modified layer and cuts the wafer W.

When the wafer W is rotated in the Rt direction, it is cut over one round of the wafer W.

Subsequently, the first optical system 40 applying the first laser L1 is moved in the direction ax1 (the position after the movement is indicated as a first optical system 40-1). Similarly, the second optical system 50 applying the second laser L2 is moved in a direction ax2 (the position after the movement is indicated as the second optical system 50-1). As a result, the irradiation position 72 becomes a new irradiation position. The wafer W is cut at this place in the same manner as above. When the wafer W is rotated in the Rt direction, it is cut over one round of the wafer W.

The distance 73 between the two irradiation positions 71 and 72 depends on the movement pitch of the first optical system 40 in the direction ax1 and the movement pitch of the second optical system 50 in the direction ax2. The method of adjustment is as described above.

Note that the movement pitches of the first optical system 40 and the second optical system 50 are preferably adjusted such that the irradiation positions after the movement become the same. When the irradiation position is moved from 71 to the irradiation position 72, the movement distance of the first optical system 40 and the movement distance of the second optical system 50 may be different from each other in accordance with the slope of the planned chamfer line 70. The movement distance of the first optical system 40 and the movement distance of the second optical system 50 are each preferably adjusted such that the irradiation positions of the lasers are positioned at the same place after the movement.

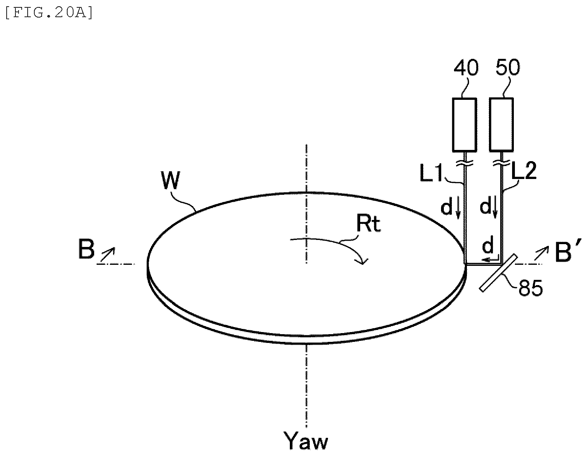

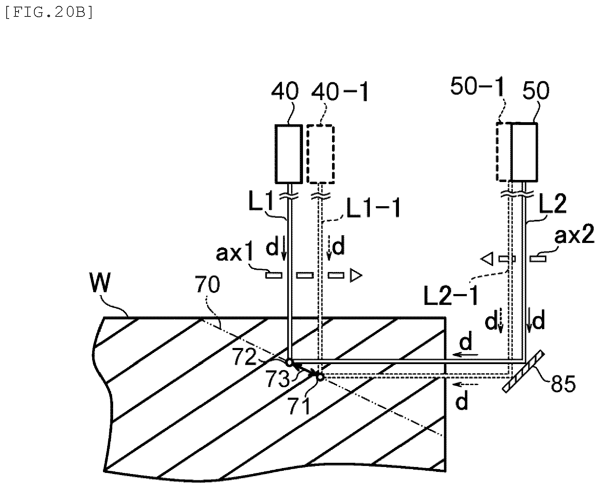

FIG. 20A and FIG. 20B are diagrams of a second modification of the method for adjusting the irradiation position. In the form in FIG. 20A and FIG. 20B as well, the first optical system 40 applying the first laser L1 and the second optical system 50 applying the second laser L2 are moved to move the irradiation position.

The second modification differs from the first modification in that the second optical system 50 includes a reflector 85 (for example, a laser mirror) reflecting the second laser.

FIG. 20A is a diagram of a positional relation when the first laser L1 is applied from the normal direction and the second laser L2 is applied from the parallel direction to the wafer W rotating in the Rt direction about the yaw axis. The first laser L1 and the second laser L2 are simultaneously applied to the same position (one irradiation position) on the end.

The chamfering device of the second modification includes the reflector 85. The reflector 85 has a function of changing the application direction of the second laser L2 output from the second optical system 50. In the second modification, both the first optical system 40 and the second optical system 50 are disposed apart from the wafer W in the normal direction to the principal surface of the wafer W.

The second laser L2 output from the second optical system 50 is reflected by the reflector 85 and applied to the side surface of the wafer W (from the parallel direction), almost perpendicularly (an incident angle of almost 0 deg).

Note that the reflector 85 may be disposed so as to be able to change the application direction of the first laser L1 from the first optical system 40. In that case, both the first optical system 40 and the second optical system 50 can be disposed in the parallel direction to the principal surface of the wafer W. In this case, the first laser L1 output from the parallel direction changes its travel direction at the reflector 85 and is applied to the irradiation position from the normal direction.

In the second modification, the first optical system 40 and the second optical system 50 are each disposed in the same direction selected from the group consisting of the normal direction and parallel direction.

Since the two optical systems are disposed adjacent to each other in the same direction, the movement direction of the optical systems can be made the same axial direction when scanning the irradiation position along the planned chamfer line 70. This makes it easier to simplify the moving mechanism. Simplification of the movement direction further reduces the manufacturing costs of the chamfering device or further improves the durability thereof.

A method for moving the optical systems in the above case will be described based on the figure. FIG. 20B is a partial sectional view of the wafer end at the B-B' line. As in FIG. 18B, this figure represents a case in which the corner is obliquely cut off to form a slope to the side surface (the outer surface) from the principal surface. That is, when it is cut in accordance with the planned chamfer line 70, the slope of the wafer W is formed.

The first laser L1 and the second laser L2 are applied to the same place (the irradiation position 71) on the planned chamfer line 70. At the irradiation position 71, the first laser L1 forms a modified layer. The second laser L2 applied simultaneously heats the formed modified layer and cuts the wafer W.

When the wafer W is rotated in the Rt direction, it is cut over one round of the wafer W.

Subsequently, the first optical system 40 applying the first laser L1 is moved in the direction ax1 (the first optical system 40-1). Similarly, the second optical system 50 applying the second laser L2 is moved in the direction ax2 (the second optical system 50-1). As a result, the irradiation position 72 becomes a new irradiation position. The wafer W is cut at this place. When the wafer W rotates in the Rt direction, the wafer W is cut over the entire perimeter thereof.

The present modification differs from the first modification in FIG. 19B in that the two optical systems are disposed in the same direction (the normal to the principal surface of the wafer W) and their movement directions (the directions ax1 and ax2) are in the same axial direction (the B-B' line direction). This further simplifies the moving mechanism. The simplified moving mechanism is also less expensive to manufacture, less prone to break down, and more durable.

Note that the adjustment of the distance 73 between the two irradiation positions 71 and 72 is the same as in the example (Example 3) and the first modification.

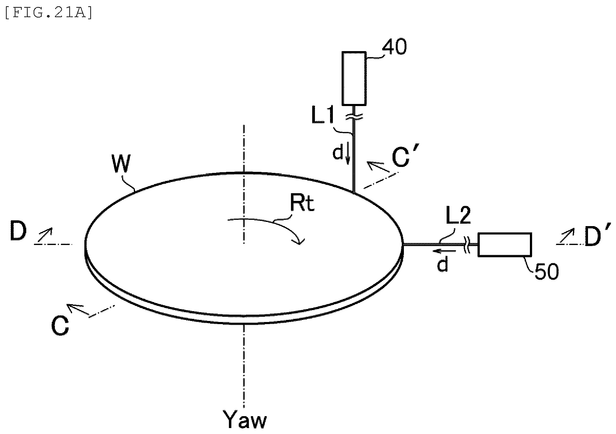

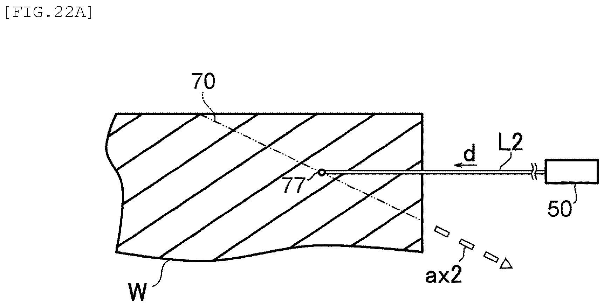

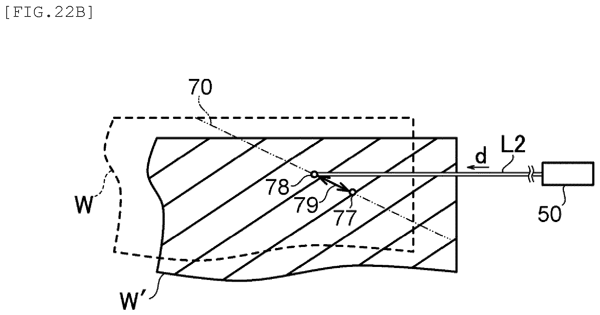

FIG. 21A to FIG. 21C, FIG. 22A, and FIG. 22B are diagrams of a third modification of the method for adjusting the irradiation position. FIG. 21A is an illustration of the positional relation among the wafer W, the first laser L1, and the second laser L2.

In the third modification, although the first laser L1 is applied from the normal direction and the second laser L2 is applied from the parallel direction to the wafer W rotating in the Rt direction about the yaw axis, their irradiation positions are different from each other. The first laser L1 and the second laser L2 are applied to different positions (two irradiation positions) on the end of the wafer W.

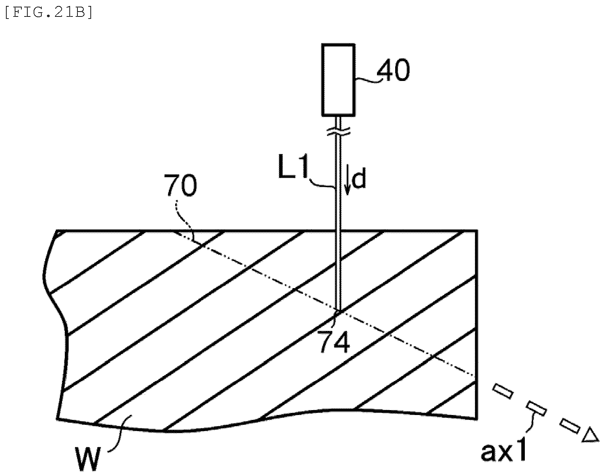

FIG. 21B is a partial sectional view of the wafer end at the C-C' line. As in each of the above examples, this figure represents a case in which the corner is obliquely cut off to form a slope to the side surface (the outer surface) from the principal surface. When it is cut in accordance with the planned chamfer line 70, the slope of the wafer W is formed.

The first laser L1 is applied such that an irradiation position 74 on the planned chamfer line 70 is a focal point. At the irradiation position 74, the first laser L1 forms a modified layer. When the wafer W is rotated in the Rt direction, the modified layer is generated in a ring shape over one round of the wafer W.

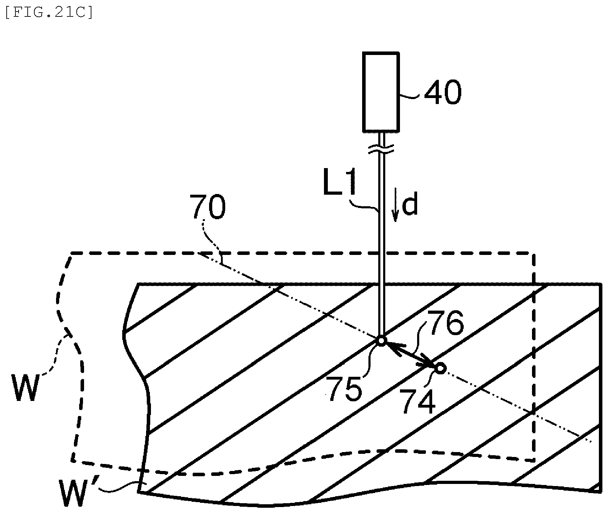

FIG. 21C is a diagram of a state (the wafer W') in which the wafer W has been moved in the direction ax1 by the moving mechanism. At this time, at an irradiation position 75, the first laser L1 forms a modified layer in the same manner as above. When the wafer W rotates in the Rt direction, this modified layer connects in a ring shape.

Note that the point that a distance 76 between the two irradiation positions 74 and 75 depends on the movement pitch of the wafer W in the ax1 direction and the method for adjusting it are the same as in the example (the third example) and the modifications described above.

FIG. 22A is a partial sectional view of the wafer end at the D-D' line of FIG. 21A.

The second laser L2 is applied to an irradiation position 77 on the planned chamfer line 70. The irradiation position 77 is almost the same position on the wafer W as the irradiation position 74, in which the first laser L1 was applied and the modified layer was formed, has been rotated. The irradiation position 74 has moved along the direction Rt due to the rotation of the wafer W, and thus the second laser L2 is applied to the irradiation position 77. Since a modified layer is formed in advance at the irradiation position 77, when the second laser L2 is applied, the wafer W is cut. When the wafer W rotates in the Rt direction in this state, the cut points connect to form a ring shape.

FIG. 22B is a diagram of a state (the wafer W') in which the wafer W has been moved in the direction ax2 by the moving mechanism. The second laser L2 is applied to an irradiation position 78 on the planned chamfer line 70. The irradiation position 77 is almost the same position on the wafer W as the irradiation position 75, in which the first laser L1 was applied and the modified layer was formed, has been rotated. The movement amount (a distance 79) from the irradiation position 77 to the irradiation position 78 is adjusted to be the same as the distance 76 in FIG. 21C.

At this time, a modified layer is formed in advance at the irradiation position 78, and when the second laser L2 is applied in the same manner as above, the wafer W is cut. When the wafer W rotates in the Rt direction in this state, the cut points connect in a ring shape.

By selecting the distance 79 between the irradiation position 77 and the irradiation position 78 as appropriate, the wafer W is cut over the entire perimeter thereof.

For efficient chamfering, it is preferable that, while the first laser L1 is continuously applied to the irradiation position 74 while the wafer W is rotated in the Rt direction, the second laser L2 be also applied to the irradiation position 77, which is positioned ahead in the rotation direction (the direction Rt) and in which the first laser L1 has already been applied. Even after the wafer W is translated in the XY directions from the irradiation position 74 to the irradiation position 75, it is preferable that the first laser L1 be applied to the irradiation position 75 and the second laser L2 be applied to the irradiation position 78 in the same manner.

In FIG. 21A to FIG. 21C, FIG. 22A, and FIG. 22B, the second optical system 50 is positioned in front of the first optical system 40 in the rotation direction of the wafer W. Thus, the modified layer formed at the irradiation position 74 of the first laser L1 is heated and cut at the irradiation position 77 of the second laser L2 after the rotation.

Compared to the example (the third example) and the other modifications, the first optical system 40 and the second optical system 50 can be disposed at positions further apart from each other. This provides a higher spatial degree of freedom and easier disposition of each piece of hardware in the chamfering device.

Note that the relation between the irradiation positions of the first laser and the second laser is not limited to the above. However, in terms of the feasibility of performing more efficient chamfering, a form in which the irradiation position 74 and the irradiation position 77 correspond to each other and the irradiation position 75 and the irradiation position 78 correspond to each other is preferred. Two irradiation positions corresponding to each other mean that they are the same position when rotated in the Rt direction. The above form is more efficient because the modified layer is formed at the irradiation position on the rear side in the rotation direction, and is heated and cut at the irradiation position on the front side in the rotation direction.

Next, a method for chamfering the notch will be described.

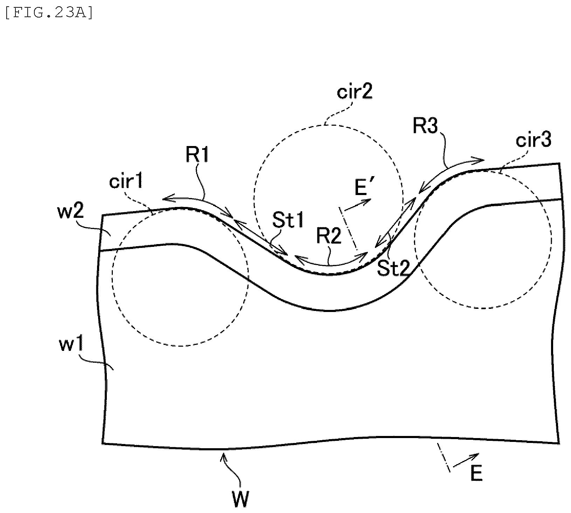

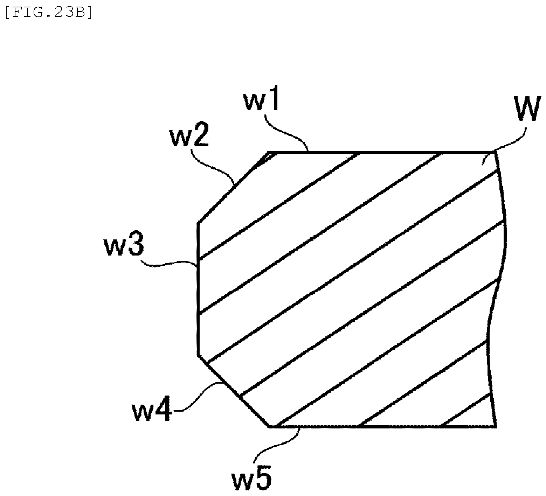

FIG. 23A and FIG. 23B are diagrams of the shape of the notch after the chamfering. FIG. 23A is a plan view. FIG. 23B is a partial sectional view of the wafer end at the E-E' line.

The shape of the notch is a complex three-dimensional shape. When the curve is sectioned, first, from the left end in FIG. 23A, it has a side R section R1, which is a curved section along the perimeter of a virtual circle cir1. Next, the side R section R1 is followed by a straight section St1. The straight section St1 is followed by a bottom R section R2, which is a curved section along the perimeter of a virtual circle cir2. The bottom R section R2 is followed by a straight section St2. The straight section St2 is followed by a side R section R3, which is a curved section along the perimeter of a virtual circle cir3.

In FIG. 23A, the virtual circles cir1, cir2, and cir3 are identical.

On the other hand, the straight section St1 and the straight section St2 have different slopes. Note that the shape of the notch can be adjusted as appropriate in accordance with the application of the wafer and the like, and is not limited to the above shape.

The sectional shape of the notch includes a principal surface w1/a slope w2 continued from the principal surface w1 to a side surface (a circumferential surface) w3/the side surface w3 perpendicular to the principal surface w1 and a principal surface w5/a slope w4 continued from the side surface w3 to the principal surface w5/the principal surface w5 parallel to the principal surface w1.

In general, the surfaces have different crystal orientations, and their physical and chemical properties are different from each other.

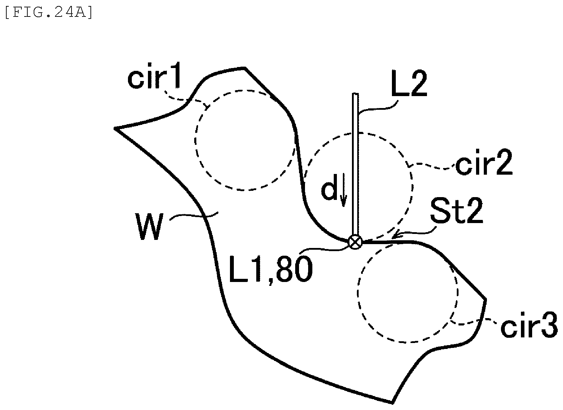

FIG. 24A to FIG. 24D are illustrations of a method for applying lasers to the notch. FIG. 24A to FIG. 24D are plan views (enlarged views from the normal direction to the principal surface of the wafer W). In all FIG. 24A to FIG. 24D, the first laser L1 is applied from the normal direction to the principal surface of the wafer W, from the front to the back of the paper. The second laser L2 is applied from a parallel direction to the principal surface of the wafer W, in parallel to the paper.

The first laser L1 is applied almost perpendicularly to the principal surface (so that the incident angle is about 0 deg). The second laser L2 is applied almost perpendicularly to the side surface (the circumferential surface).

FIG. 24A is an illustration of a method for applying lasers to the straight section St2. The wafer holding device 60 translates the wafer W in the X-, Y-, and Z-axis directions and/or rotates it about the pitch axis to adjust the incident angles of the lasers at an irradiation position 80. The irradiation position 80 is the common focal point of the first laser L1 and the second laser L2, and since the first laser L1 and the second laser L2 are applied simultaneously (or sequentially), after a modified layer is formed, the modified layer is sequentially heated and cut.

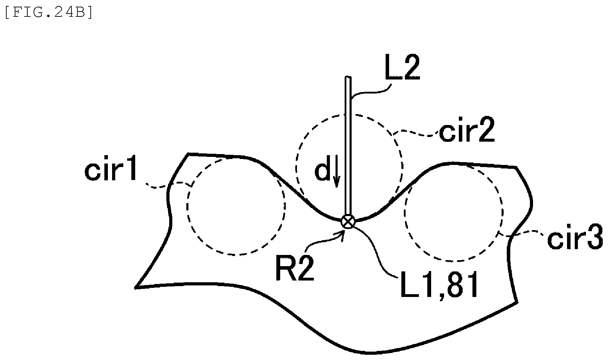

FIG. 24B is an illustration of a method for applying lasers to the bottom R section R2. As in FIG. 24A, the attitude of the wafer W is adjusted such that the incident angles of the lasers at an irradiation position 81 are within certain ranges.

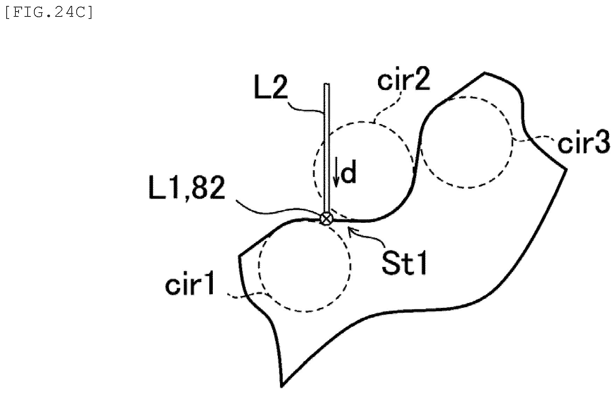

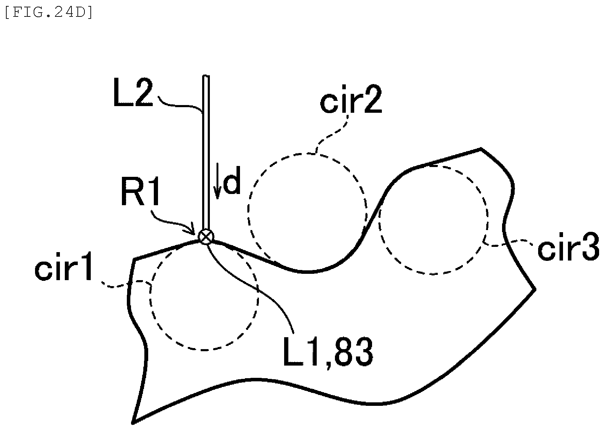

FIG. 24C is an illustration of a method for applying lasers to the straight section St1, and FIG. 24D is an illustration of a method for applying lasers to the side R section R1. The attitude of the wafer W is adjusted such that the incident angles of the lasers at an irradiation position 82 and an irradiation position 83 are within certain ranges.

By applying the lasers while moving the wafer W by the above method, the wafer W is cut along the trajectory of the irradiation position. The wafer is then moved in the Z-axis direction and the above is sequentially repeated to cut the wafer W along the planned chamfer line 70.

According to the chamfering device of the present invention, even in the chamfering of a complex notch, there is no need to obliquely apply a laser to the principal surface and the side surface of the wafer W, and the chamfering can be performed more efficiently.

Next, the method for adjusting the surface profile at Step S34 in FIG. 17 will be described.

Adjustment of the surface profile of a chamfered surface formed by laser application is typically performed for the purpose of flattening and mirroring the surface. The method is not limited to a particular method, and plasma treatment, annealing, tape polishing, and the like can be performed in combination as appropriate on the chamfered surface.

Among other things, it is preferable to apply the third laser to the chamfered surface to adjust the surface profile. The irradiation condition of the third laser is not limited to a particular condition, and can be adjusted as appropriate in accordance with the material of the wafer W, the crystal orientation of an irradiation position, and the like. Its energy density may be adjusted, in accordance with the material of the wafer W, to be less than its processing threshold.

Specifically, the control device determines cumulative irradiation energy corresponding to the crystal orientation of the irradiation position and applies the third laser (for example, a nanosecond pulsed laser). Note that continuous (CW) laser application may be used together with the application of the nanosecond pulsed laser.

The nanosecond pulsed laser is applied while changing at least one selected from the group consisting of energy density, scan pitch, and the number of times of application in accordance with the curvature of the irradiation place. For these conditions, known ones can be employed. For these conditions, for example, those described in Japanese Patent Application Laid-open No. 2022-144435 can be employed as appropriate.

Note that as a specific method, a method similar to Step S12 in the first example (FIG. 1C) can be employed. The procedure is as illustrated in FIG. 7A, FIG. 7B, and the like.

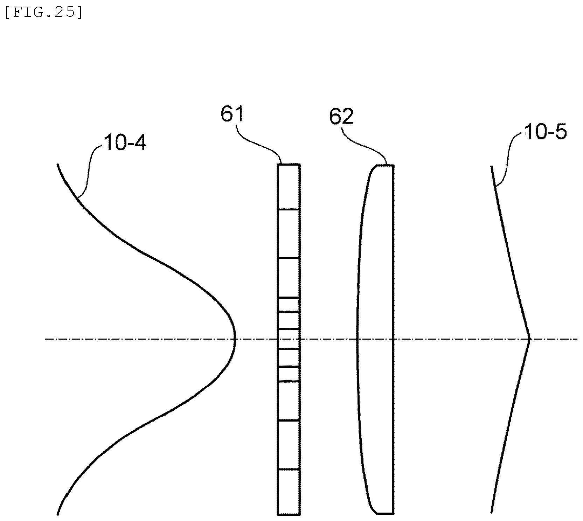

FIG. 25 is an illustration of a method for adjusting the energy density distribution of the laser used for surface treatment. A laser 10-4, the energy density distribution of which is a Gaussian distribution, is passed through a diffractive optical element (DOE) 61 and a focusing lens 62 to obtain a laser 10-5 having a certain energy density distribution.

### (Functional Block Diagram)

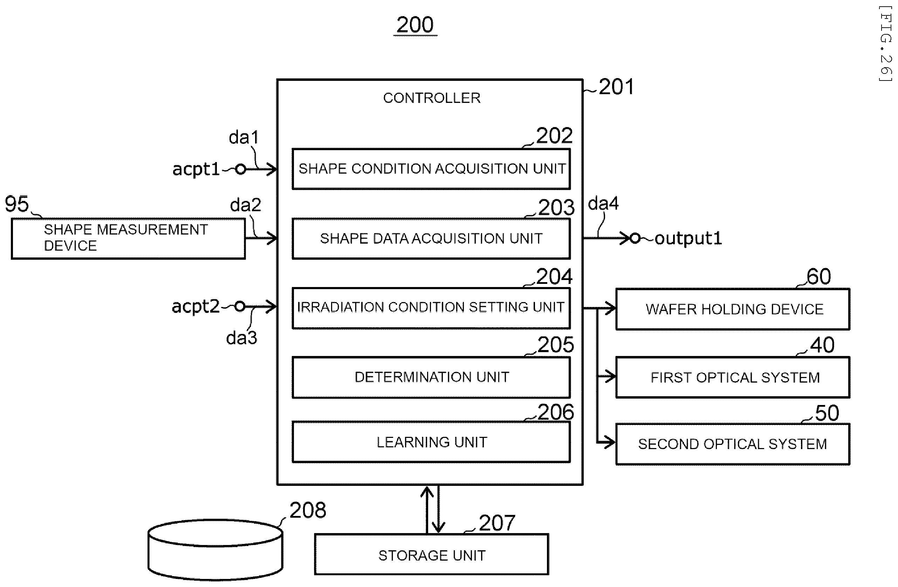

FIG. 26 is a functional block diagram of the chamfering device 200. The chamfering device 200 includes a controller 201, a storage unit 207, the shape measurement device 95, the wafer holding device 60, the first optical system 40, and the second optical system 50. The controller 201 includes a shape condition acquisition unit 202, a shape data acquisition unit 203, an irradiation condition setting unit 204, a determination unit 205, and a learning unit 206.

The controller 201 is a function implemented by executing the computer program stored in the memory 92 by the processor 91. The controller 201 controls the parts of the chamfering device 200 to cause them to implement their functions.

The shape condition acquisition unit 202 is implemented by executing the computer program stored in the memory 92 by the processor 91. The shape condition acquisition unit 202 is a function of acquiring certain data via the input and output I/F 93 and/or the communication I/F 94. The data acquired by the shape condition acquisition unit 202 is a target shape da1 input from an outside acpt1. The acquired target shape da1 is stored in the storage unit 207. The target shape da1 is used for determination described below. It is also made part of a training data set 208.

The shape data acquisition unit 203 is implemented by executing the computer program stored in the memory 92 by the processor 91. The shape data acquisition unit 203 is a function of acquiring certain data via the input and output I/F 93 and/or the communication I/F 94. One of the data to be acquired is the shape data of the wafer W before chamfering (first shape data). The first shape data is stored in the storage unit 207 and used for the determination described below.

Note that in many cases, the shape of the wafer before chamfering is almost identical, in which case the first shape data may be omitted.

The data to be acquired includes the shape data of the wafer W after chamfering (second shape data). The second shape data is also stored in the storage unit 207 and used for the determination. Note that in FIG. 26, the first shape data and the second shape data are together denoted as "shape data da2." The shape data da2 is provided from the shape measurement device 95.

The irradiation condition setting unit 204 is implemented by executing the computer program stored in the memory 92 by the processor 91. The irradiation condition setting unit 204 is a function of acquiring an irradiation condition da3 via the input and output I/F 93 and/or the communication I/F 94. The irradiation condition da3 includes settings of laser output and the like, a procedure for adjusting the attitude of the wafer W, and the like.

The irradiation condition da3 is input from an outside acpt2. The acquired data is stored in the storage unit 207 and is made part of the training data set 208.

The controller 201 controls the wafer holding device 60, the first optical system 40, and the second optical system 50 based on the irradiation condition to perform the chamfering of the wafer W.

The determination unit 205 is a function implemented by executing the computer program stored in the memory 92 by the processor 91. The determination unit 205 compares the target shape da1 acquired by the shape condition acquisition unit 202 and stored in the storage unit 207 and the shape data da2 acquired by the shape measurement device 95 with each other to determine their similarity. The method of determination is not limited to a particular method, but includes a method of comparing the target shape and the shape data with each other, quantifying the difference, and comparing the difference with a threshold set in advance. Specifically, the target shape is compared with the second shape data. The determination unit 205 outputs a determination result da4 to an outside output1. When the determination result is output, it is useful for the operator of the chamfering device 200 to devise a new irradiation condition or to improve the irradiation condition.

Note that the determination unit 205 may output the result of comparison between the target shape and the second shape to the outside output1. The operator of the chamfering device 200 checks the result of comparison and makes a pass/fail (suitability/unsuitability) determination. The determination unit 205 may acquire the result as a "determination result." In this case, the comparison with the threshold need not be performed.

The learning unit 206 is a function implemented by executing the computer program stored in the memory 92 by the processor 91.

The learning unit 206 learns the relation of the irradiation condition to the target shape, the first shape data, and the determination result by machine learning using the training data set 208 including at least the irradiation condition and the determination result.

The training data set 208 is a combination of a plurality of records containing certain information. Each record may contain at least one item selected from the group consisting of the target shape, the irradiation condition, the first shape data, the second shape data, and the determination result. Among these, each record preferably contains the target shape, the irradiation condition, and the determination result.

As a method of the machine learning, known ones can be employed. For example, regression methods, support vector machines, neural networks, and the like can be employed. Examples of the regression methods include linear regression, multiple regression, logistic regression, and Gaussian process regression.

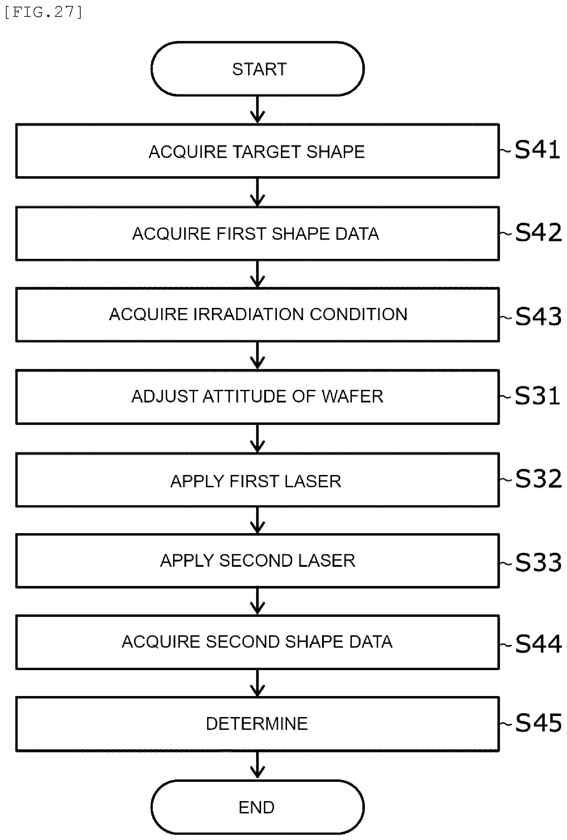

FIG. 27 is a flow diagram of a method for acquiring a record of a training data set using the chamfering device 200.

First, as Step S41, the shape condition acquisition unit 202 acquires the target shape. This has been input (or received) from the outside acpt1 via the input and output I/F 93 or the communication I/F 94.

Next, as Step S42, the shape measurement device 95 acquires the first shape data. The first shape data is the shape data of the wafer W before processing.

Next, as Step S43, the irradiation condition is acquired. The irradiation condition has been input (or received) from the outside acpt2 via the input and output I/F 93 or the communication I/F 94.

The shape of the wafer W before processing may be almost identical. The present step may be omitted.

Next, as Step S31, the attitude of the wafer W is adjusted. As Step S32, the first laser is applied from the first optical system 40 to a certain irradiation position. As Step S33, the second laser is applied from the second optical system 50 to the certain irradiation position. The controller 201 adjusts the relative position among the wafer holding device 60, the first optical system 40, and the second optical system 50 based on the input irradiation condition to perform chamfering. Note that Steps S31 to S33 may be performed simultaneously. The details of each step are the same as those of each step in the flow in FIG. 17.

Next, as Step S44, the shape measurement device 95 acquires the second shape data. The second shape data is the shape data of the wafer W after processing.

Next, as Step S45, the processing result is determined based on the result of comparison between the target shape and the second shape data. The determination result contains information on the suitability of the similarity between the target shape and the second shape data to a certain criterion or information on the suitability by the operator.

By each of the above steps, a record containing the target shape, the first shape data, the irradiation condition, the second shape data, and the determination result is obtained. A plurality of the records constitute the training data set 208. When the acquisition of the first shape data is omitted, each record does not necessarily have to contain the first shape data.

The learning unit 206 generates a learned model based on the training data set 208. The learned model has a function of outputting the irradiation condition in response to input of the target shape and the like.

When the chamfering device 200 includes the learned model generated by the learning unit 206, the irradiation condition setting unit 204 may calculate the irradiation condition from the acquired target shape and the like. The controller 201 performs the processing of the wafer W based on the calculated irradiation condition.

The chamfering device 200 can machine-learn the relation between the irradiation condition set by a skilled operator and the quality of processing (the determination result) thereby by the learning unit 206. With the learned model obtained by machine learning, the irradiation condition that can produce a high-quality processing result can be set.

Note that the chamfering device does not necessarily have to include the training unit 206 or the training data set 208. When, instead of the above, the learned model is included, the irradiation condition setting unit 204 can calculate the irradiation condition to fit from the input target shape and the like. In this case, high-quality chamfering can be performed without having to input the irradiation condition from outside.

### Reference Signs List

- 10, 10-4, 10-5: LASER
- 10-1, 41, 51: LASER LIGHT SOURCE
- 10-2: FOCUSING OPTICAL SYSTEM
- 10-3: LASER APPLICATION PART
- 16: VACUUM CHUCK TABLE
- 17: WORKPIECE MOVING STAGE
- 18: SHAPE MEASUREMENT PART
- 30, 90: CONTROL DEVICE
- 31: PROCESSING LEARNING MODEL
- 32: IRRADIATION CONDITION DATABASE
- 40: FIRST OPTICAL SYSTEM
- 50: SECOND OPTICAL SYSTEM
- 60: WAFER HOLDING DEVICE
- 100, 200: CHAMFERING DEVICE
- L: IRRADIATION SURFACE
- SL: SLOPE

## Claims

1. A chamfering method forming a slope (SL) on a perimeter of a wafer (W) to chamfer the wafer, the chamfering method is **characterized in that** it comprises:
performing pre-processing to create in advance an irradiation surface (L) to be perpendicular to the slope to be formed; and
applying a laser (10) such that the laser is perpendicularly applied to the irradiation surface to penetrate the wafer along the slope.

2. The chamfering method according to claim 1, wherein, in the applying a laser, application of a pulsed laser and application of a continuous wave laser are used together.

3. The chamfering method according to claim 2, wherein the pulsed laser has a wavelength λ of 515 nm or longer and 1,080 nm or shorter.

4. The chamfering method according to any one of claims 1 to 3, wherein a material of the wafer is SiC.

5. The chamfering method according to any one of claims 1 to 3, wherein a material of the wafer is any one selected from the group consisting of 4H-SiC, 3C-SiC, 6H-SiC, 15R-SiC, gallium nitride (GaN), gallium oxide, AlGaN, and diamond.

6. The chamfering method according to any one of claims 1 to 3, further comprising applying atmospheric pressure water vapor plasma to a cut surface with the laser.

7. The chamfering method according to any one of claims 1 to 3, further comprising performing laser annealing as finishing of a cut surface after forming the slope with the laser.

8. The chamfering method according to any one of claims 1 to 3, wherein the irradiation surface is amorphized by the pre-processing.

9. A chamfering device (100)for forming a slope (SL) on a perimeter of a wafer (W) to chamfer the wafer, the chamfering device comprising:
a laser application part (10-3) configured to apply a laser (10) to the wafer;
a workpiece moving stage (17) configured to hold the wafer and having a structure with five axes including three axes of an X axis, a Y axis, and a Z axis and additional two axes of a yaw axis for rotation and a pitch axis for tilt; and
a control device (30), wherein
the control device performs movement of the five axes with a computer program stored in advance, controls the laser application part to create in advance an irradiation surface to be perpendicular to the slope, and then applies the laser such that the laser is perpendicularly applied to the irradiation surface to penetrate the wafer along the slope.

## Patentansprüche

1. Anfasverfahren zum Bilden einer Schräge (SL) an einem Umfang eines Wafers (W), sodass der Wafer angefast wird, wobei das Anfasverfahren **dadurch gekennzeichnet ist, dass** es Folgendes umfasst:
Ausführen einer Vorbearbeitung, sodass im Voraus eine Bestrahlungsoberfläche (L) so erzeugt wird, dass sie senkrecht zu der zu bildenden Schräge ist; und
Anwenden eines Lasers (10) so, dass der Laser senkrecht auf die Bestrahlungsoberfläche angewendet wird, sodass er entlang der Schräge in den Wafer eindringt.

2. Anfasverfahren nach Anspruch 1, wobei, beim Anwenden des Lasers, eine Anwendung eines Pulslasers und eine Anwendung eines Dauerstrichlasers zusammen verwendet werden.

3. Anfasverfahren nach Anspruch 2, wobei der Pulslaser eine Wellenlänge λ von 515 nm oder länger und 1.080 nm oder kürzer aufweist.

4. Anfasverfahren nach einem beliebigen der Ansprüche 1 bis 3, wobei ein Material des Wafers SiC ist.

5. Anfasverfahren nach einem beliebigen der Ansprüche 1 bis 3, wobei ein Material des Wafers ein beliebiges ist, das ausgewählt ist aus der Gruppe bestehend aus 4H-SiC, 3C-SiC, 6H-SiC, 15R-SiC, Galliumnitrid (GaN), Galliumoxid, AlGaN und Diamant.

6. Anfasverfahren nach einem beliebigen der Ansprüche 1 bis 3, das ferner ein Anwenden von Atmosphärendruck-Wasserdampfplasma mit dem Laser auf eine geschnittene Oberfläche umfasst.

7. Anfasverfahren nach einem beliebigen der Ansprüche 1 bis 3, das nach dem Bilden der Schräge mit dem Laser ferner ein Ausführen von Laserglühen als Endbearbeitung einer geschnittenen Oberfläche umfasst.

8. Anfasverfahren nach einem beliebigen der Ansprüche 1 bis 3, wobei die Bestrahlungsoberfläche durch die Vorbearbeitung amorphisiert wird.

9. Anfasvorrichtung (100) zum Bilden einer Schräge (SL) an einem Umfang eines Wafers (W), sodass der Wafer angefast wird, wobei die Anfasvorrichtung Folgendes umfasst:
einen Laseranwendungsteil (10-3), der so ausgestaltet ist, dass er einen Laser (10) auf den Wafer anwendet;
eine Werkstückbewegungsbühne (17), die so ausgestaltet ist, dass sie den Wafer hält, und die einen Aufbau mit fünf Achsen aufweist, die drei Achsen von einer X-Achse, einer Y-Achse und einer Z-Achse und zwei zusätzliche Achsen von einer Gierachse für die Drehung und einer Nickachse für die Neigung umfassen; und
eine Steuereinrichtung (30), wobei
die Steuereinrichtung eine Bewegung der fünf Achsen mit einem im Voraus gespeicherten Computerprogramm ausführt, den Laseranwendungsteil so steuert, dass im Voraus eine Bestrahlungsoberfläche so erzeugt wird, dass sie senkrecht zu der Schräge ist, und anschließend den Laser so anwendet, dass der Laser senkrecht auf die Bestrahlungsoberfläche angewendet wird, sodass er entlang der Schräge in den Wafer eindringt.

## Revendications

1. Un procédé de chanfreinage permettant de former une pente (SL) sur le pourtour d'une plaquette de semi-conducteur (W) afin de chanfreiner la plaquette de semi-conducteur, ledit procédé de chanfreinage étant **caractérisé en ce qu'**il comprend:
la réalisation d'un prétraitement afin de créer à l'avance une surface d'irradiation (L) perpendiculaire à la pente à former; et
l'application d'un laser (10) de telle sorte que celui-ci soit appliqué perpendiculairement à la surface d'irradiation afin de pénétrer dans la plaquette de semi-conducteur le long de la pente.

2. Le procédé de chanfreinage selon la revendication 1, dans lequel, lors de l'application du laser, il est utilisé conjointement l'application d'un laser pulsé et l'application d'un laser à onde continue.

3. Le procédé de chanfreinage selon la revendication 2, dans lequel le laser pulsé a une longueur d'onde λ comprise entre 515 nm et 1080 nm.

4. Le procédé de chanfreinage selon l'une quelconque des revendications 1 à 3, dans lequel le matériau de la plaquette de semi-conducteur est du SiC.

5. Le procédé de chanfreinage selon l'une quelconque des revendications 1 à 3, dans lequel le matériau de la plaquette de semi-conducteur est choisi dans le groupe constitué par le 4H-SiC, le 3C-SiC, le 6H-SiC, le 15R-SiC, le nitrure de gallium (GaN), l'oxyde de gallium, l'AlGaN et le diamant.

6. Le procédé de chanfreinage selon l'une quelconque des revendications 1 à 3, comprenant en outre l'application d'un plasma de vapeur d'eau à pression atmosphérique sur une surface de coupe au moyen du laser.

7. Le procédé de chanfreinage selon l'une quelconque des revendications 1 à 3, comprenant en outre la réalisation d'un recuit au laser en tant que finition d'une surface de coupe après la formation de la pente au moyen du laser.

8. Le procédé de chanfreinage selon l'une quelconque des revendications 1 à 3, dans lequel la surface d'irradiation est amorphisée par le prétraitement.

9. Un dispositif de chanfreinage (100) destiné à former une pente (SL) sur le pourtour d'une plaquette de semi-conducteur (W) afin de chanfreiner la plaquette de semi-conducteur, le dispositif de chanfreinage comprenant:
une partie (10-3) d'application laser, configurée de manière à appliquer un laser (10) à la plaquette de semi-conducteur;
un plateau (17) de déplacement de la pièce, configuré de manière à maintenir la plaquette de semi-conducteur et présentant une structure à cinq axes comprenant trois axes, à savoir un axe X, un axe Y et un axe Z, ainsi que des axes supplémentaires, à savoir un axe de lacet pour une rotation et un axe de tangage pour une inclinaison; et
un dispositif de commande (30),
le dispositif de commande effectuant le déplacement des cinq axes au moyen d'un programme informatique stocké au préalable, commandant la partie d'application laser afin de créer à l'avance une surface d'irradiation devant être perpendiculaire à la pente, puis appliquant le laser de telle sorte que celui-ci soit appliqué perpendiculairement à la surface d'irradiation afin de pénétrer dans la plaquette de semi-conducteur le long de la pente.
